# EUROPEAN PATENT APPLICATION

(11) **EP 4 660 706 A2**
(43) Date of publication of application: **10.12.2025**
(21) Application number: 25178982.2
(22) Date of filing: 27.05.2025
(51) Int. Cl.: G03F 7/09

(54) **PATTERNING PROCESS**

(30) Priority: 29.05.2024 JP 2024086936
(71) Applicant: SHIN-ETSU CHEMICAL CO., LTD., Tokyo 1000005 (JP)
(72) Inventor: Kobayashi, Naoki, Niigata (JP); Yamaguchi, Hidenori, Niigata (JP); Ishiwata, Kenta, Niigata (JP)
(74) Representative: Schicker, Silvia

(57) **Abstract**

The present invention is a patterning process including the steps of: forming a resist underlayer film on a substrate; forming a silicon-containing resist middle layer film on the resist underlayer film; forming a resist upper layer film on the silicon-containing resist middle layer film; forming a pattern in the resist upper layer film; forming a resist underlayer film pattern by etching multiple times while using the resist pattern as a mask; and subjecting the resist underlayer film pattern to plasma irradiation, where the composition for forming the resist underlayer film contains a resin having an aromatic ring, and a plasma used in the plasma irradiation etches the resist underlayer film less than an etching gas used in the step of forming the resist underlayer film pattern. This can provide a method for forming a resist underlayer film pattern that exhibits better edge roughness than a conventional organic underlayer film pattern by performing plasma irradiation.

## Description

### TECHNICAL FIELD

The present invention relates to a resist underlayer film patterning process that can be used for fine patterning according to a multilayer resist method in a semiconductor device manufacturing process.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry-etched with a thinner photoresist film having lower etching resistance. Therefore, a demand for finding a composition used in this processing and the process therefor has become urgent.

A multilayer resist method is one of the solutions for the above problems. This method is as follows: a resist middle layer film having a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1, for example.

Meanwhile, in recent years, with the rapid miniaturization of DRAM memory, the proportion of edge roughness to the line width of a pattern has increased in fine patterns with high resolution in the order of nanometer, and it has become even more difficult than before to reduce the edge roughness of a pattern. Accordingly, the need for a resist underlayer film pattern having favorable edge roughness is rising. In particular, in sidewall spacer methods (Non Patent Document 1), where a pitch is divided into halves by forming films on both sides of a line pattern sidewall, reduction in the edge roughness of a resist underlayer film pattern is a problem.

As a sidewall spacer method, there is a proposal for a method of forming sidewalls with SiO₂, α-Si, α-C, etc. by a CVD method on a pattern to be a core, and then removing the core pattern by dry etching to form a pattern of the sidewalls, thus, dividing the pattern pitch into halves. In a multilayer resist method using an organic resist underlayer film and a silicon-containing middle layer film, a half-pitch pattern can be formed by transferring a resist pattern by dry etching to a core material formed from an organic underlayer film, then forming sidewalls on the core material having the transferred pattern, and subsequently removing the core material. The edge roughness of the half-pitch sidewall pattern is strongly influenced by the edge roughness of the resist underlayer film pattern to be the core.

Various methods are being considered for reducing line width variation in a pattern in a layer to be etched. As an example, there is a method of reducing the edge roughness of a resist pattern by performing plasma treatment using H₂ gas to cure the resist film (Patent Document 2).

However, in the above-described methods, when considering use as an etching mask in advanced generations, there are concerns regarding the dry etching resistance of resist patterns, and degradation in edge roughness is expected at the time of pattern transfer to a substrate to be processed. Meanwhile, when considering use as a core in a sidewall spacer method, there are concerns regarding the heat resistance of resist patterns, and degradation in edge roughness is expected at the time of sidewall formation by a CVD method.

### CITATION LIST

### PATENT LITERATURE

Patent Document 1: JP2004-205685A
Patent Document 2: JP2007-219292A

### NON PATENT LITERATURE

Non Patent Document 1: J. Vac. Sci. Technol. B17 (6), Nov/Dec 1999

### SUMMARY OF INVENTION

### TECHNICAL PROBLEM

The present invention has been made in view of the above-described circumstances. An object of the present invention is to provide a method for forming a resist underlayer film pattern that exhibits better edge roughness than a conventional organic underlayer film pattern by performing plasma irradiation.

### SOLUTION TO PROBLEM

To achieve the object, the present invention provides a patterning process for forming a resist underlayer film pattern on a substrate, comprising the steps of:
(i-1) applying a composition for forming a resist underlayer film onto a substrate, followed by heating to form a resist underlayer film;
(i-2) applying a composition for forming a silicon-containing resist middle layer film onto the resist underlayer film, followed by heating to form a silicon-containing resist middle layer film;
(i-3) forming a resist upper layer film on the silicon-containing resist middle layer film;
(i-4) subjecting the resist upper layer film to pattern exposure and then development with a developer to form a pattern in the resist upper layer film;
(i-5) forming a resist underlayer film pattern by etching multiple times while using the pattern of the resist upper layer film as a mask; and
(i-6) subjecting the resist underlayer film pattern to plasma irradiation, wherein
   the composition for forming a resist underlayer film contains a resin having an aromatic ring, and
   a plasma used in the plasma irradiation in the step (i-6) etches the resist underlayer film less than an etching gas used in the step (i-5) of forming the resist underlayer film pattern by etching the resist underlayer film.

According to such a resist underlayer film patterning process, the film surface on the sidewalls of the pattern is modified by plasma irradiation, and a resist underlayer film pattern having excellent edge roughness can be formed.

The present invention also provides a patterning process for forming a resist underlayer film pattern on a substrate, comprising the steps of:
(ii-1) applying a composition for forming a resist underlayer film onto a substrate, followed by heating to form a resist underlayer film;
(ii-2) forming an inorganic hard mask middle layer film selected from a silicon oxide film, a silicon nitride film, and a silicon oxynitride film on the resist underlayer film;
(ii-3) forming a resist upper layer film on the inorganic hard mask middle layer film;
(ii-4) subjecting the resist upper layer film to pattern exposure and then development with a developer to form a pattern in the resist upper layer film;
(ii-5) forming a resist underlayer film pattern by etching multiple times while using the pattern of the resist upper layer film as a mask; and
(ii-6) subjecting the resist underlayer film pattern to plasma irradiation, wherein
   the composition for forming a resist underlayer film contains a resin having an aromatic ring, and
   a plasma used in the plasma irradiation in the step (ii-6) etches the resist underlayer film less than an etching gas used in the step (ii-5) of forming the resist underlayer film pattern by etching the resist underlayer film.

According to such a resist underlayer film patterning process, the film surface on the sidewalls of the pattern is modified by plasma irradiation, and a resist underlayer film pattern having excellent edge roughness can be formed.

In this case, the patterning process can comprise, after the step of performing plasma irradiation, a step of forming the pattern directly or indirectly on the substrate while using the plasma-irradiated resist underlayer film pattern as an etching mask.

In the inventive patterning process, the pattern can be formed on the substrate in this manner.

In the patterning process, the step of performing plasma irradiation is preferably performed under an atmosphere of N₂, NF₃, H₂, fluorocarbon, a rare gas, or a mixture thereof.

When the plasma irradiation of the resist underlayer film pattern is performed under an atmosphere containing a gas given above, edge roughness can be improved while suppressing side-etching of the resist underlayer film pattern.

In this case, the step of performing plasma irradiation is preferably performed under an atmosphere containing hydrogen or helium.

As described, a gas containing H₂ or helium is also preferable from the viewpoint of productivity.

In the above-described patterning process, the composition for forming a resist underlayer film preferably comprises (A) a resin, being:
(a) a polymer having an aromatic ring in a main chain and having a weight-average molecular weight of 2,500 or higher and 20,000 or lower as measured by gel permeation chromatography in terms of polystyrene;
(b) an aromatic ring-containing compound having a weight-average molecular weight of 600 or more and 3,000 or less as measured by gel permeation chromatography in terms of polystyrene; or a combination thereof.

According to the patterning process using the composition for forming a resist underlayer film containing the resin (A), the modification caused by the plasma irradiation occurs easily, and it is possible to form a resist underlayer film pattern having better edge roughness.

In this case, the resin (A) preferably has at least one crosslinkable group selected from a vinyl group, an allyl group, an allyloxy group, an ethynyl group, a propargyl group, a propargyloxy group, an epoxy group, an oxetanyl group, and a hydroxy group.

The resin (A) having a crosslinkable group given above has excellent curability, and therefore, according to a patterning process using the composition for forming a resist underlayer film containing the resin, a fine resist underlayer film pattern can be formed. A resist underlayer film pattern thus obtained undergoes modification caused by the plasma irradiation more easily, and a resist underlayer film pattern having excellent edge roughness can be formed.

In the above-described patterning process for forming a half-pitch pattern of the pattern of the resist upper layer film on the substrate, the patterning process preferably comprises,
after the step of subjecting the resist underlayer film pattern to plasma irradiation, the steps of:
forming an inorganic silicon film comprising any of polysilicon, amorphous silicon, silicon oxide, silicon nitride, silicon oxynitride, silicon carbide, and composite materials thereof by a CVD method or an ALD method to cover the resist underlayer film pattern; and
removing the resist underlayer film pattern by dry etching or with a peeling solution to form an inorganic silicon film pattern having a half pitch of the pattern of the resist upper layer film.

According to such a patterning process, a resist underlayer film pattern having excellent edge roughness can be formed, and therefore, when the pattern is used as a core for a sidewall spacer method, it is possible to achieve better edge roughness of the half-pitch sidewall pattern.

### ADVANTAGEOUS EFFECTS OF INVENTION

As explained above, in recent years, with the rapid miniaturization of DRAM, the proportion of edge roughness to the line width of a pattern has increased in fine patterns with high resolution in the order of nanometer, and it has become even more difficult than before to reduce the edge roughness of a pattern. Accordingly, the need is rising for a resist underlayer film pattern having excellent edge roughness. In particular, in sidewall spacer methods, where a pitch is divided into halves by forming films on both sides of a line pattern sidewall, reduction in the edge roughness of a resist underlayer film pattern is a problem. The inventive resist underlayer film patterning process can provide a resist underlayer film pattern that exhibits better edge roughness than a conventional organic underlayer film pattern by performing plasma irradiation, and therefore, can be used particularly suitably in a multilayer resist process, and is extremely useful in fine patterning for manufacturing a semiconductor device.

### BRIEF DESCRIPTION OF DRAWINGS

FIG. 1 is an explanatory diagram of an example of the inventive patterning process (three-layer resist process).
FIG. 2 is an explanatory diagram of an example of the inventive patterning process (sidewall spacer method).
FIG. 3 is an explanatory diagram of an example of the inventive patterning process (sidewall spacer method using wet peeling).
FIG. 4 is an explanatory diagram of an example of the inventive patterning process (sidewall spacer method).
FIG. 5 is an explanatory diagram of another example of the inventive patterning process (sidewall spacer method).

### DESCRIPTION OF EMBODIMENTS

As explained above, there have been demands for the development of: a method for forming a resist underlayer film pattern according to which a resist pattern can be transferred to a substrate to be processed with higher precision in a fine patterning process using a multilayer resist method; and a resist underlayer film pattern useful as a core material in a sidewall spacer method.

The present inventors have searched for a method for forming a resist underlayer film pattern with small edge roughness and studied earnestly, and found out that a resist underlayer film pattern having small edge roughness can be formed by transferring a resist upper layer film pattern, by dry etching, to a resist underlayer film formed by using a composition for forming a resist underlayer film containing a resin having an aromatic ring, and then performing plasma irradiation. Thus, the present invention has been completed.

That is, the present invention is a patterning process for forming a resist underlayer film pattern on a substrate, comprising the steps of:
(i-1) applying a composition for forming a resist underlayer film onto a substrate, followed by heating to form a resist underlayer film;
(i-2) applying a composition for forming a silicon-containing resist middle layer film onto the resist underlayer film, followed by heating to form a silicon-containing resist middle layer film;
(i-3) forming a resist upper layer film on the silicon-containing resist middle layer film;
(i-4) subjecting the resist upper layer film to pattern exposure and then development with a developer to form a pattern in the resist upper layer film;
(i-5) forming a resist underlayer film pattern by etching multiple times while using the pattern of the resist upper layer film as a mask; and
(i-6) subjecting the resist underlayer film pattern to plasma irradiation, wherein
   the composition for forming a resist underlayer film contains a resin having an aromatic ring, and
   a plasma used in the plasma irradiation in the step (i-6) etches the resist underlayer film less than an etching gas used in the step (i-5) of forming the resist underlayer film pattern by etching the resist underlayer film.

The present invention is also a patterning process for forming a resist underlayer film pattern on a substrate, comprising the steps of:
(ii-1) applying a composition for forming a resist underlayer film onto a substrate, followed by heating to form a resist underlayer film;
(ii-2) forming an inorganic hard mask middle layer film selected from a silicon oxide film, a silicon nitride film, and a silicon oxynitride film on the resist underlayer film;
(ii-3) forming a resist upper layer film on the inorganic hard mask middle layer film;
(ii-4) subjecting the resist upper layer film to pattern exposure and then development with a developer to form a pattern in the resist upper layer film;
(ii-5) forming a resist underlayer film pattern by etching multiple times while using the pattern of the resist upper layer film as a mask; and
(ii-6) subjecting the resist underlayer film pattern to plasma irradiation, wherein
   the composition for forming a resist underlayer film contains a resin having an aromatic ring, and
   a plasma used in the plasma irradiation in the step (ii-6) etches the resist underlayer film less than an etching gas used in the step (ii-5) of forming the resist underlayer film pattern by etching the resist underlayer film.

Hereinafter, the present invention will be described in detail, but the present invention is not limited thereto.

### [Patterning Process]

The present invention provides a patterning process for forming a resist underlayer film pattern on a substrate, including the steps of:
(i-1) applying a composition for forming a resist underlayer film onto a substrate, followed by heating to form a resist underlayer film;
(i-2) applying a composition for forming a silicon-containing resist middle layer film onto the resist underlayer film, followed by heating to form a silicon-containing resist middle layer film;
(i-3) forming a resist upper layer film on the silicon-containing resist middle layer film;
(i-4) subjecting the resist upper layer film to pattern exposure and then development with a developer to form a pattern in the resist upper layer film;
(i-5) forming a resist underlayer film pattern by etching multiple times while using the pattern of the resist upper layer film as a mask; and
(i-6) subjecting the resist underlayer film pattern to plasma irradiation, where
   the composition for forming a resist underlayer film contains a resin having an aromatic ring, and
   a plasma used in the plasma irradiation in the step (i-6) etches the resist underlayer film less than an etching gas used in the step (i-5) of forming the resist underlayer film pattern by etching the resist underlayer film.

Note that, in the present invention, it is necessary to use, as a plasma used in the plasma irradiation in the step (i-6), a plasma that etches the resist underlayer film less than an etching gas used in the step (i-5). When a plasma that etches the resist underlayer film less than an etching gas used in the step (i-5) is used as a plasma used in the plasma irradiation in the step (i-6), a pattern of the resist underlayer film can be obtained in the step (i-5), and meanwhile, it is possible to avoid the pattern of the resist underlayer film obtained in the step (i-6) being damaged or lost.

Furthermore, the present invention may also be a patterning process for forming a resist underlayer film pattern on a substrate, including the steps of:
(ii-1) applying a composition for forming a resist underlayer film onto a substrate, followed by heating to form a resist underlayer film;
(ii-2) forming an inorganic hard mask middle layer film selected from a silicon oxide film, a silicon nitride film, and a silicon oxynitride film on the resist underlayer film;
(ii-3) forming a resist upper layer film on the inorganic hard mask middle layer film;
(ii-4) subjecting the resist upper layer film to pattern exposure and then development with a developer to form a pattern in the resist upper layer film;
(ii-5) forming a resist underlayer film pattern by etching multiple times while using the pattern of the resist upper layer film as a mask; and
(ii-6) subjecting the resist underlayer film pattern to plasma irradiation, where
   the composition for forming a resist underlayer film contains a resin having an aromatic ring, and
   a plasma used in the plasma irradiation in the step (ii-6) etches the resist underlayer film less than an etching gas used in the step (ii-5) of forming the resist underlayer film pattern by etching the resist underlayer film.

Note that, as stated above, in the present invention, it is necessary to use, as a plasma used in the plasma irradiation in the step (ii-6), a plasma that etches the resist underlayer film less than an etching gas used in the step (ii-5). When a plasma that etches the resist underlayer film less than an etching gas used in the step (ii-5) is used as a plasma used in the plasma irradiation in the step (ii-6), a pattern of the resist underlayer film can be obtained in the step (ii-5), and meanwhile, it is possible to avoid the pattern of the resist underlayer film obtained in the step (ii-6) being damaged or lost.

Specific examples of the inventive patterning process include the following patterning processes.

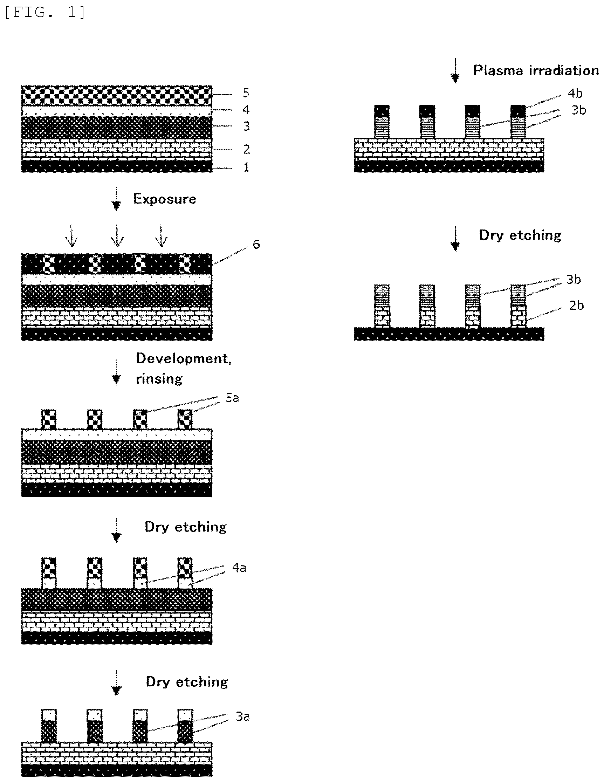

An explanatory diagram of an example of the inventive patterning process (three-layer resist process) is shown in FIG. 1. On a substrate (1) to be processed having a layer (2) to be processed, a resist underlayer film (3), a silicon-containing middle layer film (4), and a resist upper layer film (5) are formed. The resist upper layer film is exposed (6), and removal is performed by development and rinsing to form a resist upper layer film pattern (5a). Dry etching is performed while using the obtained resist upper layer film pattern (5a) as a mask for transfer to obtain a silicon-containing middle layer film pattern (4a) and a resist underlayer film pattern (3a), and then plasma irradiation is performed. The plasma-irradiated silicon-containing middle layer film pattern (4b) and resist underlayer film pattern (3b) are transferred by dry etching to the layer (2) to be processed to form a layer-to-be-processed pattern (2b).

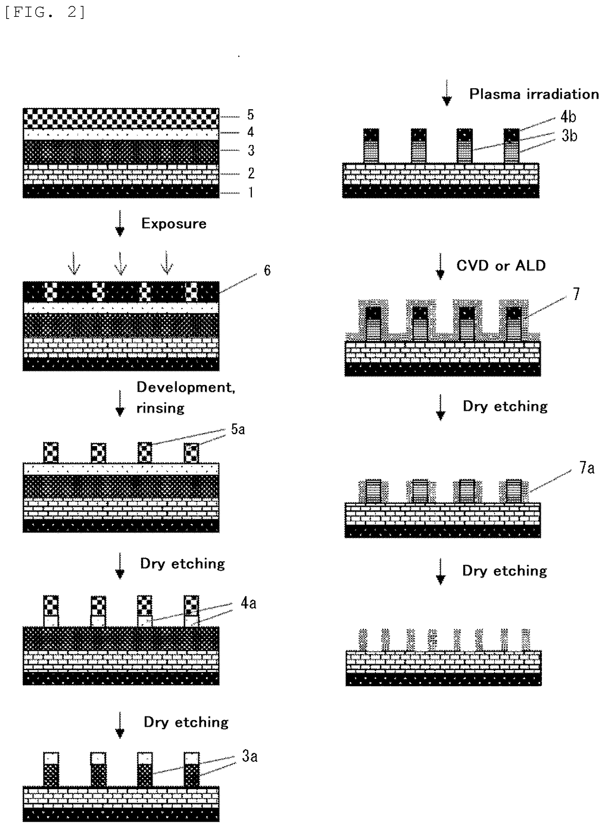

An explanatory diagram of another example of the inventive patterning process (sidewall spacer method) is shown in FIG. 2. A resist underlayer film (3), a silicon-containing middle layer film (4), and a resist upper layer film (5) are formed on a substrate (1) to be processed having a layer (2) to be processed. The resist upper layer film is exposed (6), and removal is performed by development and rinsing to form a resist upper layer film pattern (5a). Dry etching is performed while using the obtained resist upper layer film pattern (5a) as a mask for transfer to obtain a silicon-containing middle layer film pattern (4a) and a resist underlayer film pattern (3a), and then plasma irradiation is performed. The plasma-irradiated silicon-containing middle layer film pattern (4b) and resist underlayer film pattern (3b) are covered with an inorganic silicon film (7) by CVD or ALD, and then dry etching is performed to remove the silicon-containing middle layer film pattern (4b) and resist underlayer film pattern (3b). Thus, an inorganic silicon film pattern (7a) is formed.

In the following, each step is described in detail in turn.

### [Step (i-1) and Step (ii-1)]

Step (i-1) and step (ii-1) are steps of forming a resist underlayer film on a substrate.

### <Substrate>

As the substrate, it is possible to use, for example, a substrate in which any of a metal film, a metal carbide film, a metal oxide film, a metal nitride film, and a composite of these films is formed as a layer to be processed (portion to be processed) on a substrate for manufacturing a semiconductor.

As the substrate for manufacturing a semiconductor, a silicon substrate is generally used, but the substrate is not particularly limited, and it is possible to use Si, amorphous silicon (α-Si), p-Si, SiO₂, SiN, SiON, W, TiN, Al, etc., being a material different from that of the layer to be processed. As the metal constituting the layer to be processed, it is possible to use silicon, titanium, tungsten, hafnium, zirconium, chromium, germanium, copper, aluminum, iron, or an alloy thereof. As a layer to be processed containing such metal, it is possible to use, for example, Si, SiO₂, SiN, SiON, SiOC, p-Si, α-Si, TiN, WSi, BPSG, SOG, Cr, CrO, CrON, MoSi, W, W-Si, Al, Cu, Al-Si, etc., and various low dielectric films and etching stopper films therefor. The layer can usually be formed to have a thickness of 50 to 10,000 nm, particularly 100 to 5,000 nm.

### <Organic Resist Underlayer Film>

The composition for forming an organic underlayer film used in the present invention is preferably a resin having an aromatic ring from the viewpoints of film-formability in spin-coating, curability, etching resistance, optical characteristics, heat resistance, etc. Furthermore, when the resin contains an aromatic ring, the modification of the film caused by plasma irradiation occurs easily, and a resist underlayer film pattern having small edge roughness can be formed.

Examples of the aromatic ring include benzene, naphthalene, anthracene, pyrene, indene, fluorene, furan, pyrrole, thiophene, phosphole, pyrazole, oxazole, isoxazole, thiazole, pyridine, pyrazine, pyrimidine, pyridazine, triazine, carbazole, etc. Among these, benzene, naphthalene, and fluorene are particularly preferable.

It is more preferable that the composition for forming a resist underlayer film contains (A) a resin, being:
(a) a polymer having an aromatic ring in a main chain and having a weight-average molecular weight of 2,500 or higher and 20,000 or lower as measured by gel permeation chromatography in terms of polystyrene;
(b) an aromatic ring-containing compound having a weight-average molecular weight of 600 or more and 3,000 or less as measured by gel permeation chromatography in terms of polystyrene; or a combination thereof.

It is further preferable that the resin (A) has at least one crosslinkable group selected from a vinyl group, an allyl group, an allyloxy group, an ethynyl group, a propargyl group, a propargyloxy group, an epoxy group, an oxetanyl group, and a hydroxy group.

The resin (A) having a crosslinkable group given above has excellent curability, and therefore, according to a patterning process using the composition for forming a resist underlayer film containing the resin, a fine resist underlayer film pattern can be formed. A resist underlayer film pattern thus obtained undergoes modification caused by the plasma irradiation more easily, and a resist underlayer film pattern having excellent edge roughness can be formed.

Examples of resins having an aromatic ring applicable to the present invention include resins containing the following structures, disclosed in JP2012-1687A and JP2012-77295A.

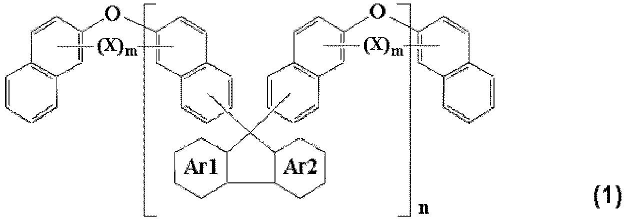

In the formula (1), the cyclic structures Ar1 and Ar2 each represent a benzene ring or a naphthalene ring. X represents a single bond or an alkylene group having 1 to 20 carbon atoms. "m" represents 0 or 1. "n" represents any natural number that provides a molecular weight of 100,000 or less. Note that the symbols in the formula apply only in this formula.

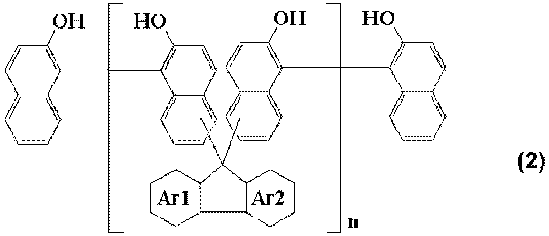

In the formula (2), the cyclic structures Ar1 and Ar2 each represent a benzene ring or a naphthalene ring. "n" represents any natural number that provides a weight-average molecular weight of 100,000 or less as measured by gel permeation chromatography in terms of polystyrene. Note that the symbols in the formula apply only in this formula.

Further examples of resins having an aromatic ring applicable to the present invention include resins containing the following structures, disclosed in JP2004-264710A, JP2005-043471A, JP2005-250434A, JP2007-293294A, and JP2008-65303A.

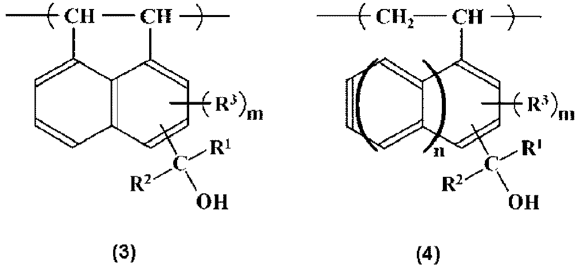

In the formula (3) and the formula (4), R¹ and R² each represent a hydrogen atom, an alkyl group having 1 to 3 carbon atoms, or an aryl group; R³ represents an alkyl group having 1 to 3 carbon atoms, a vinyl group, an allyl group, or an aryl group that is optionally substituted; "n" represents 0 or 1; and "m" represents 0, 1, or 2. Note that the symbols in the formulae apply only in these formulae.

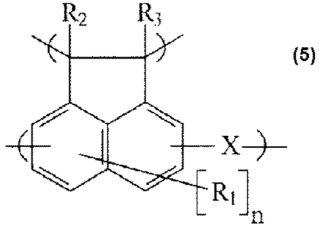

In the formula (5), R₁ represents a monovalent atom other than a hydrogen atom or a monovalent group; and "n" represents an integer of 0 to 4. Here, when "n" is 2 to 4, the multiple R₁'s may be identical to or different from each other. R₂ and R₃ each independently represent a monovalent atom or group. X represents a divalent group. Note that the symbols in the formula apply only in this formula.

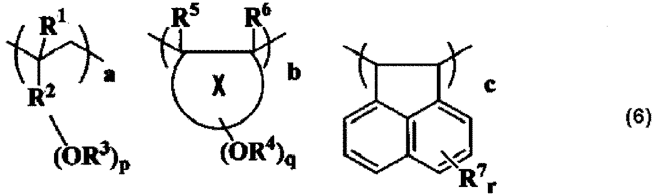

In the formula (6), R¹ represents a hydrogen atom or a methyl group. R² represents a single bond, a linear, branched, or cyclic alkylene group having 1 to 20 carbon atoms, or an arylene group having 6 to 10 carbon atoms, and may have any of ether, ester, lactone, and amide. R³ and R⁴ each represent a hydrogen atom or a glycidyl group. X represents any polymer of any of a hydrocarbon including an indene skeleton, a cycloolefin having 3 to 10 carbon atoms, and maleimide, and may have any of ether, ester, lactone, and carboxylic anhydride. R⁵ and R⁶ each represent a hydrogen atom, a fluorine atom, a methyl group, or a trifluoromethyl group. R⁷ represents a hydrogen atom, a linear, branched, or cyclic alkyl group having 1 to 6 carbon atoms, a hydroxy group, or an alkoxycarbonyl group. "p" and "q" each represent an integer of 1 to 4. "r" represents an integer of 0 to 4. "a", "b", and "c" each satisfy 0.5 ≤ a+b+c ≤ 1, 0 ≤ a ≤ 0.8, 0 ≤ b ≤ 0.8, 0.1 ≤ a+b ≤ 0.8, and 0.1 ≤ c ≤ 0.8. Note that the symbols in the formula apply only in this formula.

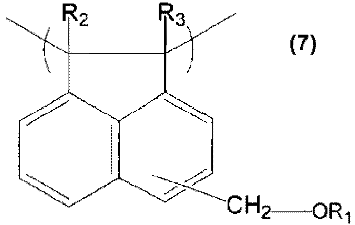

In the formula (7), R₁ represents a hydrogen atom or a monovalent organic group; and R₂ and R₃ each independently represent a monovalent atom or a monovalent organic group. Note that the symbols in the formula apply only in this formula.

Specific examples of resins having an aromatic ring applicable to the present invention include resins containing the following structures, disclosed in JP2004-205685A, JP2007-171895A, and JP2009-14816A.

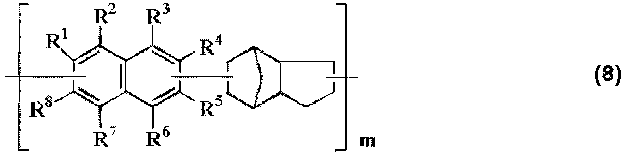

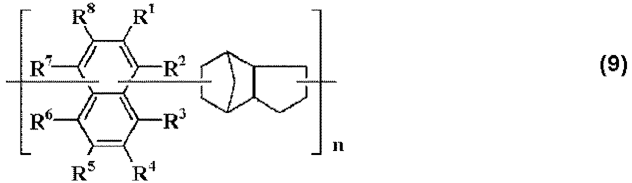

In the formula (8) and the formula (9), R¹ to R⁸ each independently represent a hydrogen atom, a hydroxy group, an alkyl group having 1 to 6 carbon atoms and optionally being substituted, an alkoxy group having 1 to 6 carbon atoms and optionally being substituted, an alkoxycarboxy group having 2 to 6 carbon atoms and optionally being substituted, an aryl group having 6 to 10 carbon atoms and optionally being substituted, a hydroxyalkyl group having 1 to 6 carbon atoms, an isocyanate group, or a glycidyl group. "m" and "n" each represent a positive integer. Note that the symbols in the formulae apply only in these formulae.

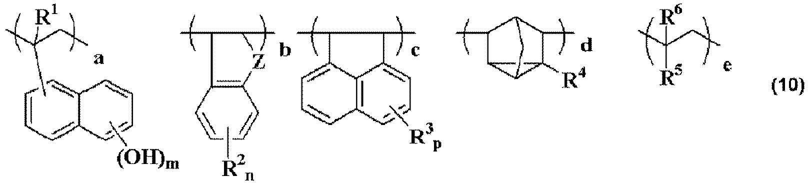

In the formula (10), R¹ and R⁶ each represent a hydrogen atom or a methyl group. R², R³, and R⁴ each represent a hydrogen atom, an alkyl group having 1 to 4 carbon atoms, an alkoxy group, a hydroxy group, an acetoxy group, an alkoxycarbonyl group, or an aryl group having 6 to 10 carbon atoms; R⁵ represents a condensed polycyclic hydrocarbon group having 13 to 30 carbon atoms, -O-R⁷, -C(=O)-O-R⁷, -O-C(=O)-R⁷, or -C(=O)-NR^{B}-R⁷; "m" represents 1 or 2; "n" represents an integer of 0 to 4; and "p" represents an integer of 0 to 6. R⁷ represents an organic group having 7 to 30 carbon atoms; R⁸ represents a hydrogen atom or a hydrocarbon group having 1 to 6 carbon atoms. Z represents a methylene group, -O-, -S-, or -NH-. "a", "b", "c", "d", and "e" each satisfy 0 < a < 1.0, 0 ≤ b ≤ 0.8, 0 ≤ c ≤ 0.8, 0 < d ≤ 0.8, 0 ≤ e ≤ 0.8, and 0 < b+c+d+e < 1.0. Note that the symbols in the formula apply only in this formula.

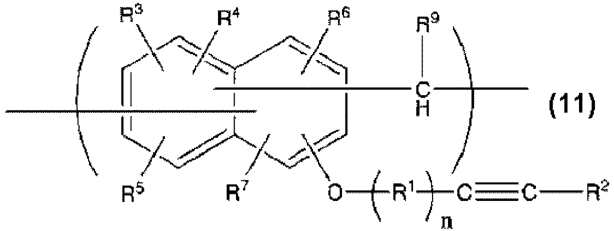

In the formula, "n" represents 0 or 1. R¹ represents a methylene group that is optionally substituted, an alkylene group having 2 to 20 carbon atoms and optionally being substituted, or an arylene group having 6 to 20 carbon atoms and optionally being substituted. R² represents a hydrogen atom, an alkyl group having 1 to 20 carbon atoms and optionally being substituted, or an aryl group having 6 to 20 carbon atoms and optionally being substituted. R³ to R⁷ each represent a hydroxy group, an alkyl group having 1 to 6 carbon atoms and optionally being substituted, an alkoxy group having 1 to 6 carbon atoms and optionally being substituted, an alkoxycarbonyl group having 2 to 10 carbon atoms and optionally being substituted, an aryl group having 6 to 14 carbon atoms and optionally being substituted, or a glycidyl ether group having 2 to 6 carbon atoms and optionally being substituted. R⁹ represents a hydrogen atom, a linear, branched, or cyclic alkyl group having 1 to 10 carbon atoms, a linear, branched, or cyclic alkyl ether group having 1 to 10 carbon atoms, or an aryl group having 6 to 10 carbon atoms. Note that the symbols in the formula apply only in this formula.

Examples include the following compounds.

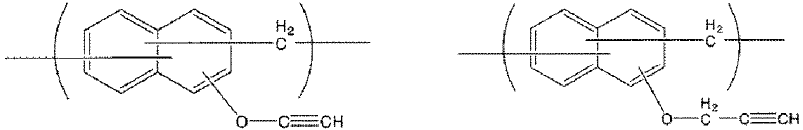

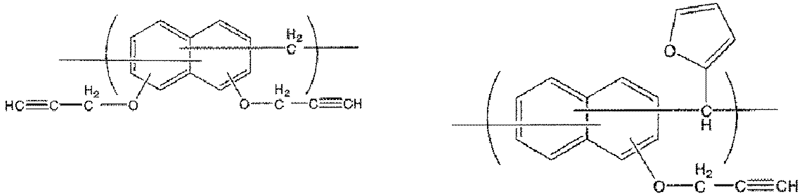

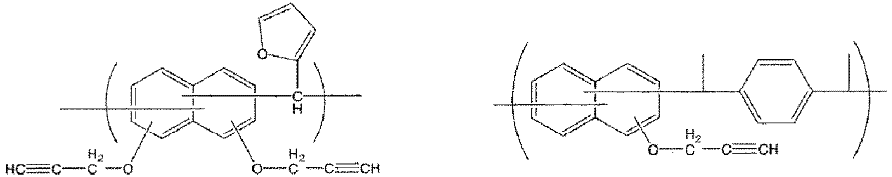

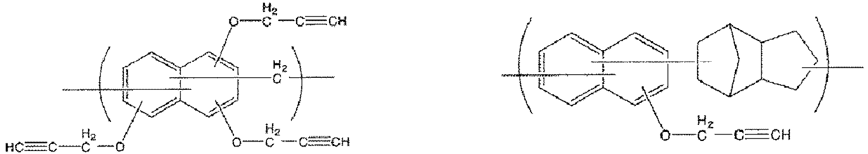

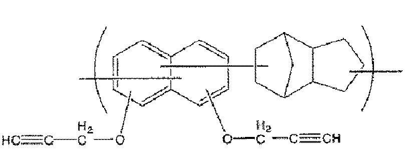

Examples of resins having an aromatic ring applicable to the present invention include resins containing the following structures, disclosed in JP2007-199653A, JP2008-274250A, and JP2010-122656A.

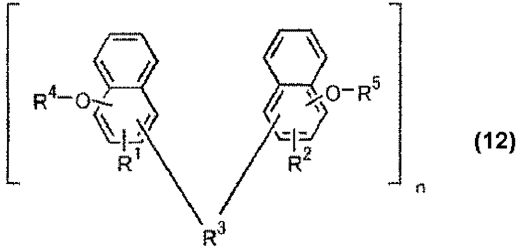

In the formula (12), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and "n" represents an integer of 1 to 4. Note that the symbols in the formula apply only in this formula.

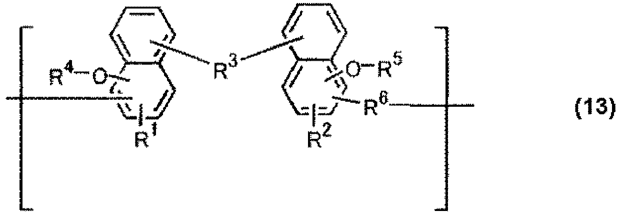

In the formula (13), R¹ and R² are identical to or different from each other and each independently represent a hydrogen atom, a linear, branched, or cyclic alkyl group having 1 to 10 carbon atoms, an aryl group having 6 to 10 carbon atoms, or an alkenyl group having 2 to 10 carbon atoms; R³ represents a single bond or a linear, branched, or cyclic alkylene group having 1 to 30 carbon atoms, and optionally has a bridged cyclic hydrocarbon group, a double bond, a heteroatom, or an aromatic group having 6 to 30 carbon atoms; R⁴ and R⁵ each independently represent a hydrogen atom or a glycidyl group; and R⁶ represents a single bond or a linear or branched alkylene group having 1 to 10 carbon atoms. Note that the symbols in the formula apply only in this formula.

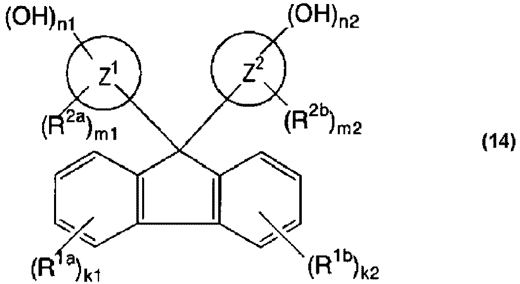

In the formula (14), the ring Z¹ and the ring Z² each represent a condensed polycyclic aromatic hydrocarbon ring; and R^{1a}, R^{1b}, R^{2a}, and R^{2b} are identical to or different from each other and each represent a substituent. "k1" and "k2" may be identical to or different from each other and each represent 0 or an integer of 1 to 4; "m1" and "m2" each represent 0 or an integer of 1 or more; and "n1" and "n2" each independently represent 0 or an integer of 1 or more. Here, n1+n2 ≥ 1. Note that the symbols in the formula apply only in this formula.

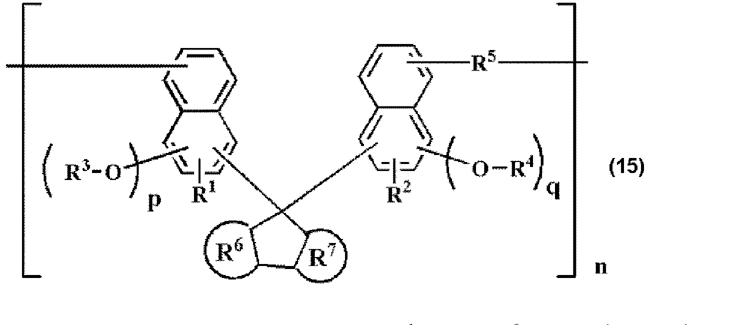

In the formula (15), R¹ and R² are identical to or different from each other, and each represent a hydrogen atom, a linear, branched, or cyclic alkyl group having 1 to 10 carbon atoms, an aryl group having 6 to 10 carbon atoms, or an alkenyl group having 2 to 10 carbon atoms. R³ and R⁴ each represent a hydrogen atom or a glycidyl group; R⁵ represents a single bond or a linear or branched alkylene group having 1 to 10 carbon atoms; and R⁶ and R⁷ each represent a benzene ring or a naphthalene ring. "p" and "q" each represent 1 or 2. "n" satisfies 0 < n ≤ 1. Note that the symbols in the formula apply only in this formula.

Examples include the following compounds.

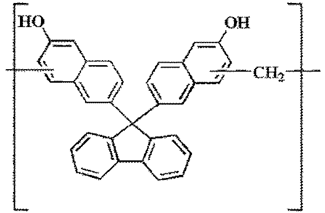

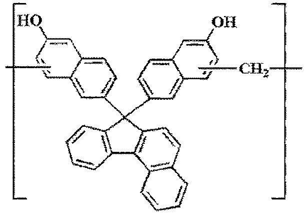

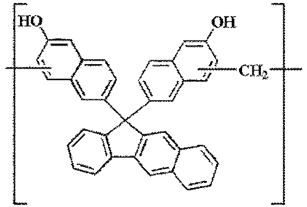

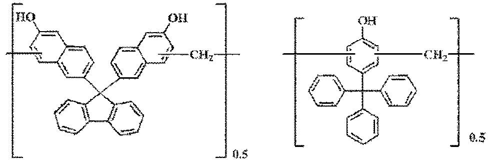

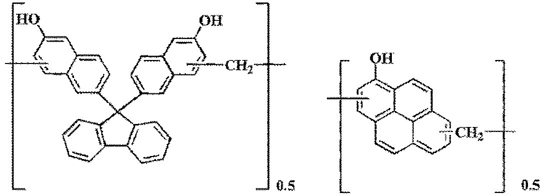

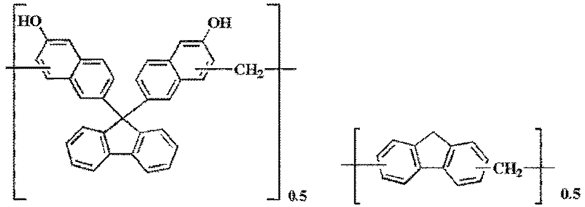

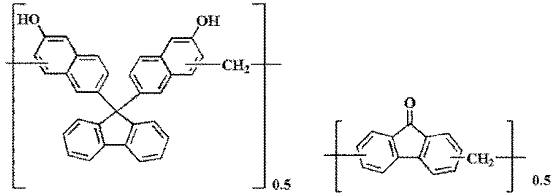

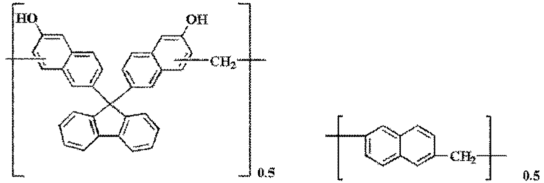

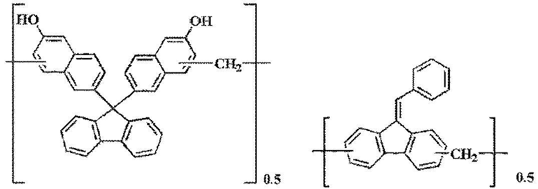

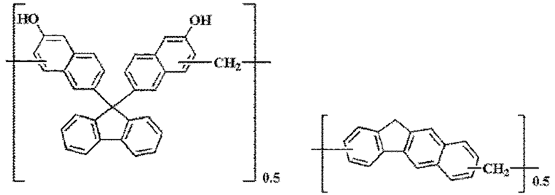

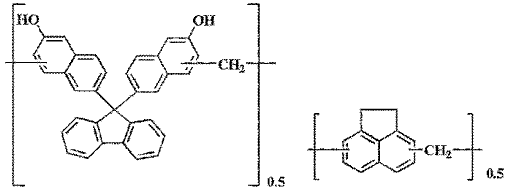

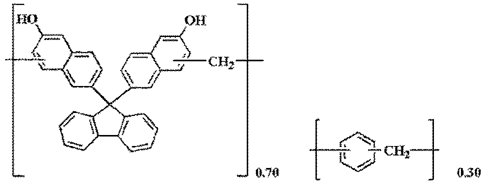

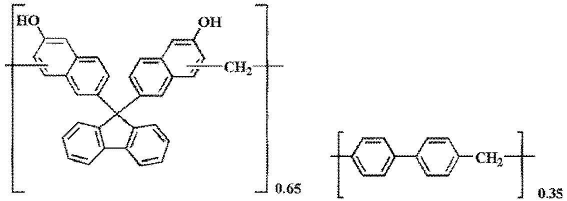

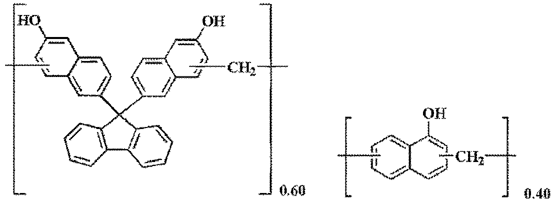

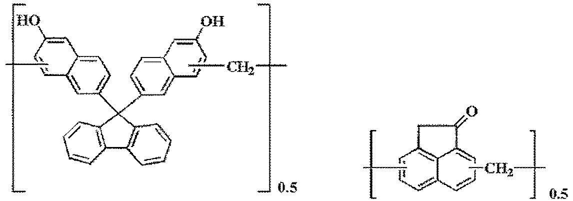

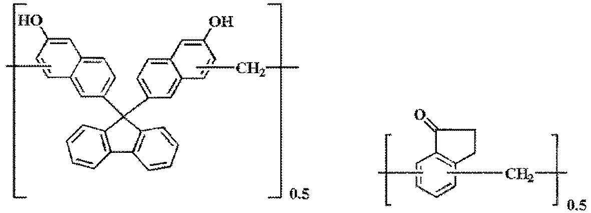

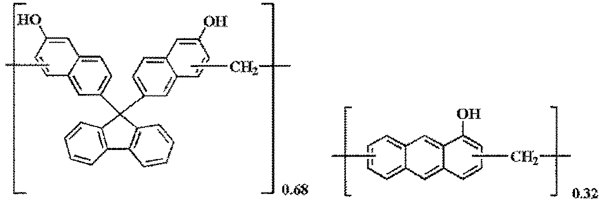

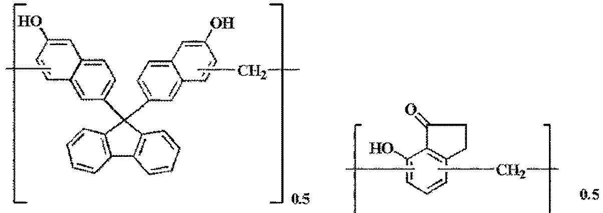

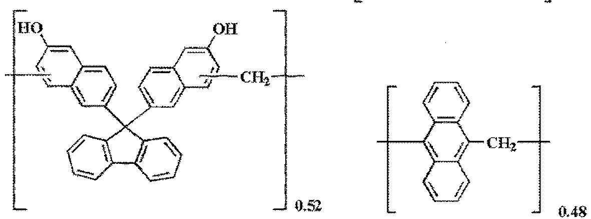

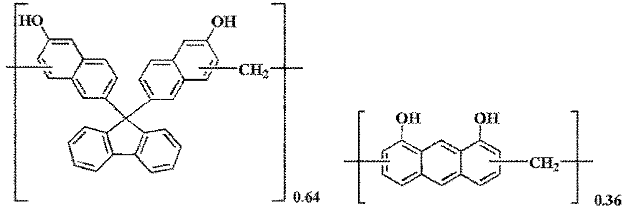

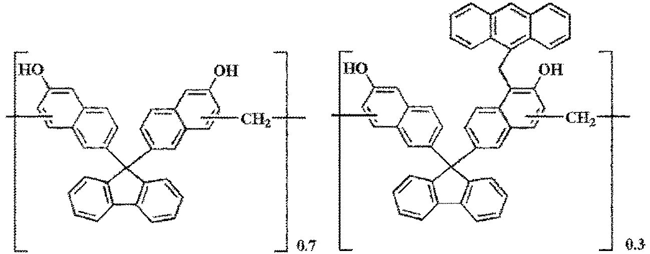

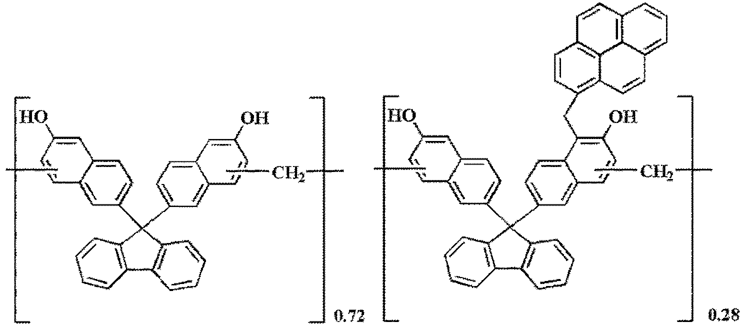

Examples of resins having an aromatic ring applicable to the present invention include resins disclosed in JP2014-29435A, WO2012/077640A1, and WO2010/147155A1.

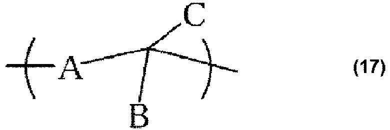

In the formula (17), A represents a structure having carbazole, B represents a structure having an aromatic ring, and C represents a hydrogen atom, an alkyl group, or a structure having an aromatic ring, B and C optionally constituting a ring with each other. One to four carboxy groups, a salt thereof, or a carboxylic acid ester group is contained in the combined structure of A, B, and C. Note that the symbols in the formula apply only in this formula.

Further examples include polymers disclosed in WO2012/077640A1, the polymers containing a unit structure represented by the following formula (18) and a unit structure represented by the following formula (19), where the ratio of the unit structure represented by the formula (18) to the unit structure represented by the formula (19) is 3 to 97 : 97 to 3 by molar ratio.

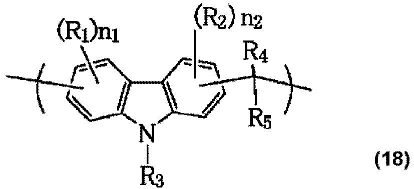

In the formula (18), R₁ and R₂ each independently represent a hydrogen atom, a halogen atom, a nitro group, an amino group, a hydroxy group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₃ represents a hydrogen atom, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₄ represents a hydrogen atom, or an aryl group or heterocyclic group having 6 to 40 carbon atoms and optionally being substituted with a halogen atom, a nitro group, an amino group, or a hydroxy group; R₅ represents a hydrogen atom, or an alkyl group having 1 to 10 carbon atoms, aryl group having 6 to 40 carbon atoms, or heterocyclic group optionally substituted with a halogen atom, a nitro group, an amino group or a hydroxy group; and R₄ and R₅ may form a ring with each other. "n1" and "n2" each represent an integer of 1 to 3. Note that the symbols in the formula apply only in this formula.

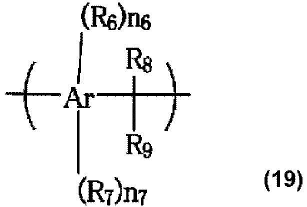

In the formula (19), Ar represents an aromatic ring group having 6 to 20 carbon atoms; R₆ represents a hydroxy group; and R₇ represents a hydrogen atom, a halogen atom, a nitro group, an amino group, an alkyl group having 1 to 10 carbon atoms, an alkenyl group having 2 to 10 carbon atoms, an aryl group having 6 to 40 carbon atoms, or a combination of the groups, optionally including an ether bond, a ketone bond, or an ester bond. R₈ represents a hydrogen atom, or an aryl group or heterocyclic group having 6 to 40 carbon atoms and optionally substituted with a halogen atom, a nitro group, an amino group, or a hydroxy group; R₉ represents a hydrogen atom, or an alkyl group having 1 to 10 carbon atoms optionally substituted with a halogen atom, a nitro group, an amino group, or a hydroxy group, an aryl group having 6 to 40 carbon atoms optionally substituted with a halogen atom, a nitro group, an amino group, or a hydroxy group, or a heterocyclic group optionally substituted with a halogen atom, a nitro group, an amino group, or a hydroxy group; and R₈ and R₉ may form a ring with each other. "n6" represents an integer of 1 to "p", "n7" represents an integer of p-n6. Here, "p" is the maximum number of substituents with which the aromatic ring group Ar can be substituted. Note that the symbols in the formula apply only in this formula.

Examples of resins having an aromatic ring applicable to the present invention include polymers containing a unit structure represented by the following formula (20), disclosed in WO2010/147155A1.

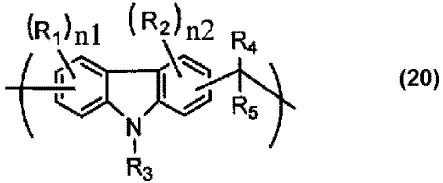

In the formula (20), R₁ and R₂ are each selected from the group consisting of a hydrogen atom, a halogen group, a nitro group, an amino group, a hydroxy group, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₃ is selected from the group consisting of a hydrogen atom, alkyl groups having 1 to 10 carbon atoms, alkenyl groups having 2 to 10 carbon atoms, aryl groups having 6 to 40 carbon atoms, and combinations thereof, the alkyl groups, the alkenyl groups, or the aryl groups optionally containing an ether bond, a ketone bond, or an ester bond; R₄ represents an aryl group or heterocyclic group having 6 to 40 carbon atoms and optionally substituted with a halogen group, a nitro group, an amino group, or a hydroxy group; R₅ represents a hydrogen atom or an alkyl group having 1 to 10 carbon atoms or an aryl group or heterocyclic group having 6 to 40 carbon atoms and optionally substituted with a halogen group, a nitro group, an amino group, or a hydroxy group; R₄ and R₅ optionally form a ring together with the carbon atom bonded to R₄ and R₅; and "n1" and "n2" each represent an integer of 1 to 3. Note that the symbols in the formula apply only in this formula.

Examples of resins having an aromatic ring applicable to the present invention include: novolak resins obtained by a reaction between one or more phenols, such as phenol, cresol, xylenol, catechol, resorcinol, hydroquinone, pyrogallol, hydroxyquinol, and phloroglucinol, and one or more aldehyde sources, such as formaldehyde, paraformaldehyde, and trioxane, in the presence of an acid catalyst; and resins containing a repeating unit structure represented by the following formula (21), disclosed in WO2012/176767A1.

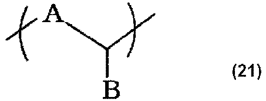

In the formula (21), A represents a hydroxy group-substituted phenylene group derived from polyhydroxybenzene; and B represents a monovalent condensed aromatic hydrocarbon ring group in which two to six benzene rings are condensed. Note that the symbols in the formula apply only in this formula.

Examples of resins having an aromatic ring applicable to the present invention include novolak resins having a fluorene or tetrahydrospirobiindene structure, disclosed in JP2005-128509A, JP2006-259249A, JP2006-259482A, JP2006-293298A, and JP2007-316282A, the novolak resins containing a repeating unit structure represented by the following formula (22-1) or (22-2).

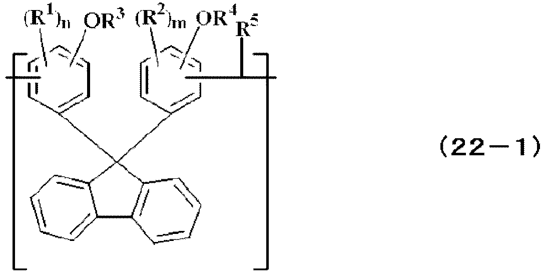

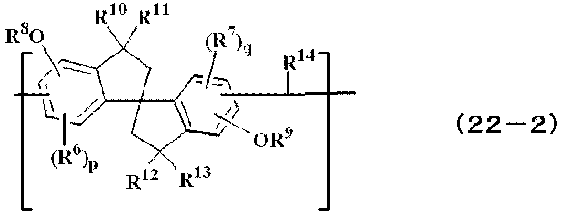

In the formula (22-1) and the formula (22-2), R¹, R², R⁶, and R⁷ each independently represent a hydrogen atom, a linear, branched, or cyclic alkyl group having 1 to 10 carbon atoms, an aryl group having 6 to 10 carbon atoms, an allyl group, or a halogen atom; R³, R⁴, R⁸, and R⁹ each independently represent a hydrogen atom, a linear, branched, or cyclic alkyl group having 1 to 6 carbon atoms, a linear, branched, or cyclic alkenyl group having 2 to 6 carbon atoms, an aryl group having 6 to 10 carbon atoms, or a glycidyl group; and R⁵ and R¹⁴ each independently represent a hydrogen atom, a linear, branched, or cyclic alkyl group having 1 to 10 carbon atoms, or an aryl group having 6 to 10 carbon atoms. "n", "m", "p", and "q" each represent an integer of 1 to 3. R¹⁰ to R¹³ each independently represent a hydrogen atom, a halogen atom, a hydroxy group, a linear, branched, or cyclic alkyl group having 1 to 6 carbon atoms, or a linear, branched, or cyclic alkoxy group having 1 to 6 carbon atoms. Note that the symbols in the formulae apply only in these formulae.

Examples of resins having an aromatic ring applicable to the present invention include reaction products obtained by a method disclosed in JP2012-145897A.

More specific examples include polymers obtained by condensing one or more compounds represented by the following general formula (23-1) and/or (23-2) and one or more compounds represented by the following general formula (24-1) and/or (24-2) and/or an equivalent thereof.

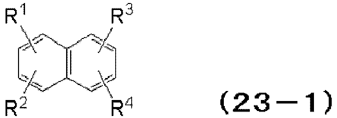

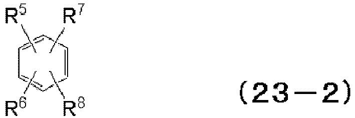

In the formula (23-1) and the formula (23-2), R¹ to R⁸ each independently represent a hydrogen atom, a halogen atom, a hydroxy group, an isocyanato group, a glycidyloxy group, a carboxy group, an amino group, an alkoxy group having 1 to 30 carbon atoms, an alkoxycarbonyl group having 1 to 30 carbon atoms, an alkanoyloxy group having 1 to 30 carbon atoms, or a saturated or unsaturated organic group having 1 to 30 carbon atoms and optionally being substituted. Furthermore, any two substituents selected from each of R¹ to R⁴ or R⁵ to R⁸ may be bonded to each other within a molecule to form a cyclic substituent. Note that the symbols in the formulae apply only in these formulae.

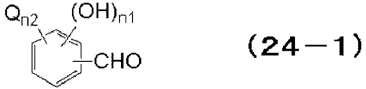

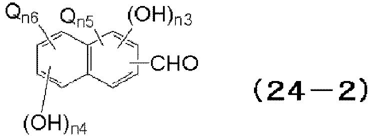

In the formula (24-1) and the formula (24-2), Q represents an organic group having 1 to 30 carbon atoms and optionally being substituted, and furthermore, any two Q's selected therefrom are optionally bonded with each other within a molecule to form a cyclic substituent. "n1" to "n6" each represent the number of each substituent, "n1" to "n6" are each independently 0, 1, or 2, and in the formula (24-1), hydroxybenzaldehyde is excluded. Meanwhile, in the formula (24-2), the relationships 0 ≤ n3+n5 ≤ 3, 0 ≤ n4+n6 ≤ 4, and 1 ≤ n3+n4 ≤ 4 are satisfied. Note that the symbols in the formulae apply only in these formulae.

Further examples also include polymers obtained by condensing one or more compounds represented by the general formula (23-1) and/or (23-2), one or more compounds represented by the general formula (24-1) and/or (24-2) and/or an equivalent thereof, and one or more compounds represented by the following general formula (25) and/or an equivalent thereof.

Y-CHO (25)

In the formula (25), Y represents a hydrogen atom or a monovalent organic group having 30 or fewer carbon atoms and optionally having a substituent, and the formula (25) is different from the formula (24-1) and the formula (24-2). Note that the symbol in the formula applies only in this formula.

Examples of resins having an aromatic ring applicable to the present invention include polymers having a repeating unit represented by the following general formula (27-1), disclosed in JP2019-44022A.

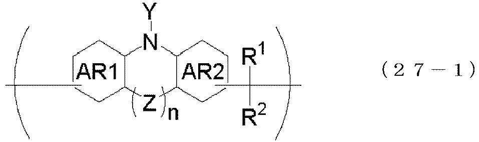

In the formula (27-1), AR1 and AR2 each represent a benzene ring or naphthalene ring optionally having a substituent. R¹ and R² each independently represent a hydrogen atom or an organic group having 1 to 30 carbon atoms, and when R¹ and R² each represent an organic group, R¹ and R² are optionally bonded to each other within a molecule to form a cyclic organic group. "n" represents 0 or 1; when n = 0, AR1 and AR2 do not form a bridged structure between the aromatic rings of AR1 and AR2 via Z; when n = 1, AR1 and AR2 form a bridged structure between the aromatic rings of AR1 and AR2 via Z; and Z represents a single bond or one of the following formulae (27-2). Y represents a group represented by the following formula (27-3). Note that the symbols in the formula apply only in this formula.

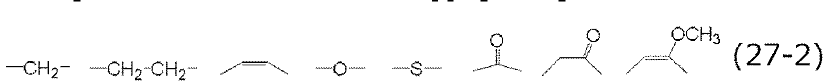

----R³-C≡C-R⁴ (27-3)

In the formula, R³ represents a single bond or a divalent organic group having 1 to 20 carbon atoms; R⁴ represents a hydrogen atom or a monovalent organic group having 1 to 20 carbon atoms; and a broken line represents an attachment point. Note that the symbols in the formula apply only in this formula.

Examples include the following polymers.

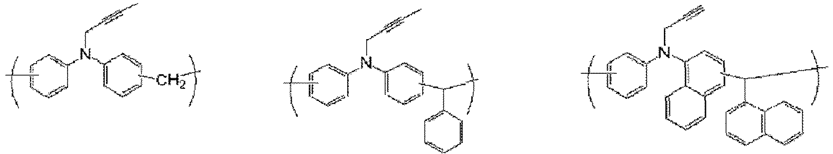

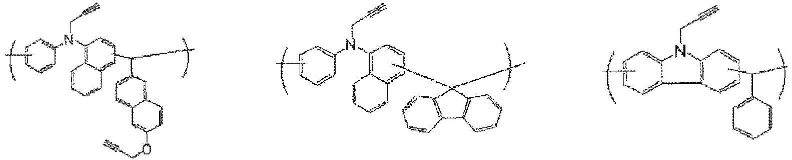

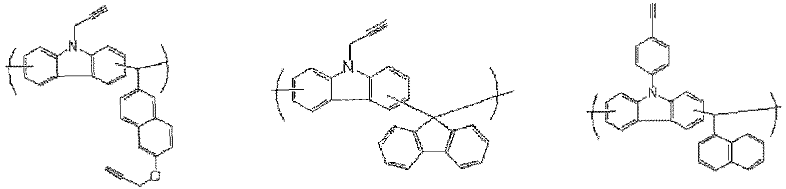

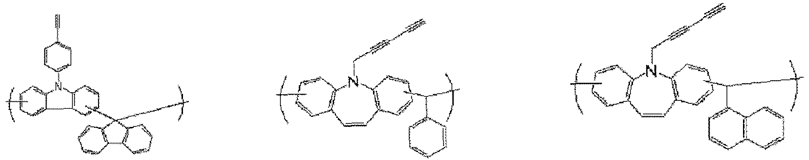

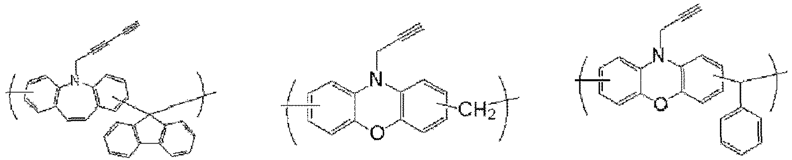

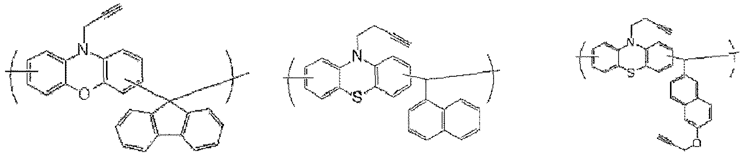

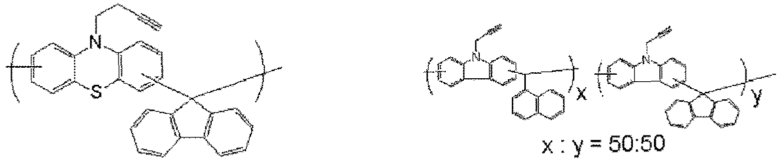

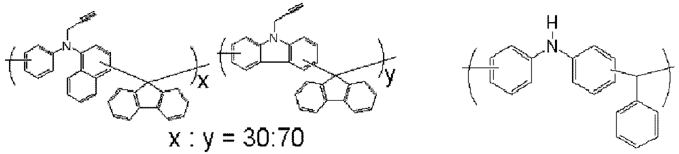

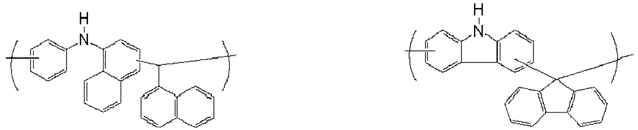

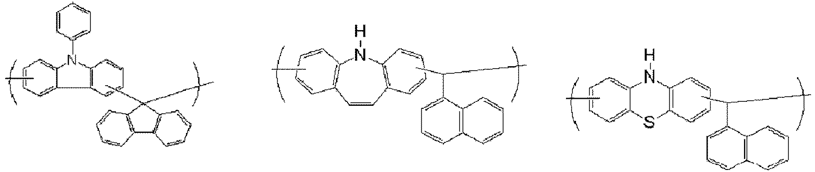

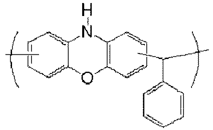

The resin having an aromatic ring may be synthesized by a known method, and a commercially available product may be used.

Examples of resins having an aromatic ring applicable to the present invention include resins containing the following structure, disclosed in JP2012-214720A.

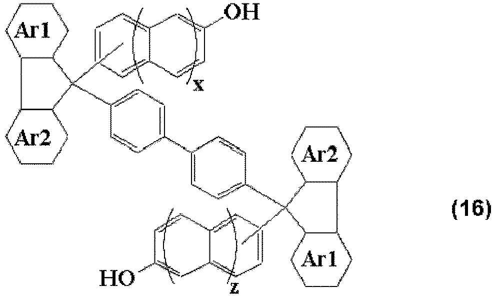

In the formula (16), the cyclic structures Ar1 and Ar2 each represent a benzene ring or a naphthalene ring. "x" and "z" each independently represent 0 or 1. Note that the symbols in the formula apply only in this formula.

Examples of resins having an aromatic ring applicable to the present invention include resins containing the following structure, disclosed in JP2017-119671A.

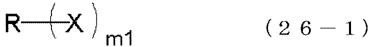

In the formula (26-1), R represents a single bond or an organic group having 1 to 50 carbon atoms; X represents a group represented by any of the following general formulae (26-2); and "m1" represents an integer that satisfies 2 ≤ m1 ≤ 10. Note that the symbols in the formula apply only in this formula.

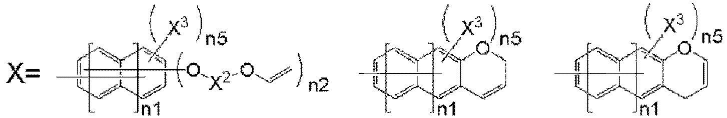

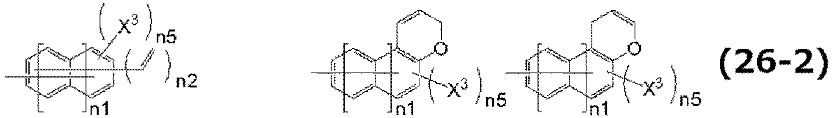

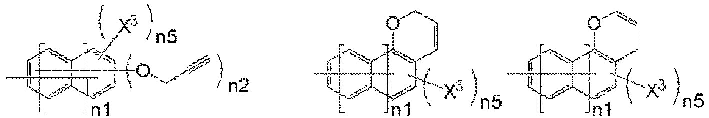

In the formulae, X² represents a divalent organic group having 1 to 10 carbon atoms; "n1" represents 0 or 1; "n2" represents 1 or 2; X³ represents a group represented by the following general formula (26-3); and "n5" represents 0, 1, or 2. Note that the symbols in the formulae apply only in these formulae.

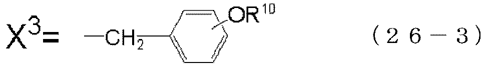

In the formula, R¹⁰ represents a hydrogen atom or a saturated or unsaturated hydrocarbon group having 1 to 10 carbon atoms, and a hydrogen atom on the benzene ring in the formula may be substituted with a methyl group or a methoxy group. Note that the symbol in the formula applies only in this formula.

Examples include the following compounds.

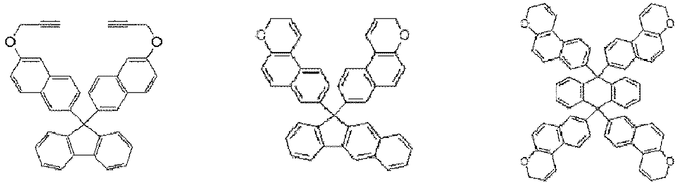

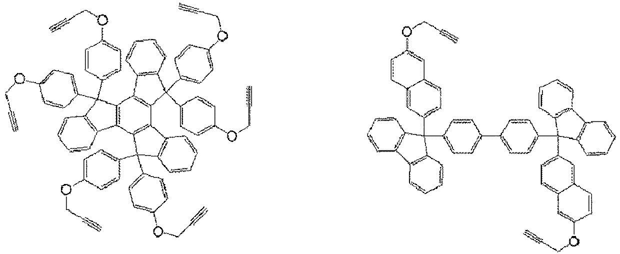

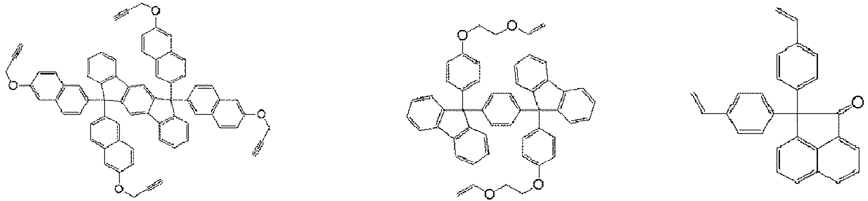

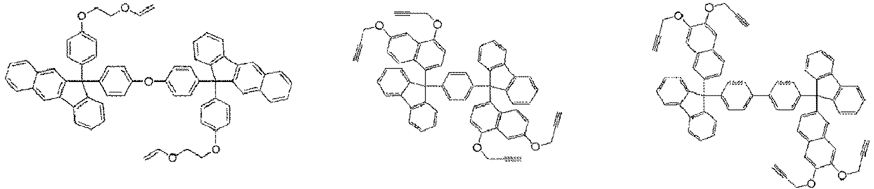

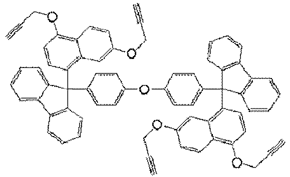

The method for applying the composition for forming a resist underlayer film in the step (i-1) and step (ii-1) is not particularly limited. Details of the composition for forming a resist underlayer film will be given later.

In the step (i-1) and step (ii-1), the heating (baking) temperature of the coating film can be 100°C or higher and 800°C or lower, more preferably 150°C or higher and 600°C or lower, further preferably 150°C or higher and 450°C or lower, and even further preferably 200°C or higher and 400°C or lower. The baking time can be 10 seconds to 7,200 seconds, further preferably 30 seconds to 600 seconds.

By adjusting appropriately the baking temperature and time within the above-described ranges, it is possible to achieve curing properties, such as planarizing and filling properties, dry etching resistance, and heat resistance, suitable for the purpose. By performing the heat treatment (baking) within a temperature range of 150°C or higher and 600°C or lower, a state is achieved, where many active sites, at which dissociation and recombination of carbon bonds in the underlayer film occurs, are contained in the film, and film modification by irradiation with plasma is more easily promoted, so that a resist underlayer film pattern having small edge roughness can be formed after the plasma irradiation. When the baking temperature is 100°C or higher, the solvent remaining in the film can be reduced, and degradation in film shrinkage due to plasma irradiation can be suppressed. When the baking temperature is 800°C or lower, thermal decomposition of the base resin can be suppressed, and it is possible to provide a resist underlayer film with little sublimation product. It is also possible to perform the heat treatment in multiple steps (step-baking).

Furthermore, in the step (i-1) and step (ii-1), the heat treatment can be performed under an atmosphere having an oxygen concentration of 1% or more and 21% or less.

According to such a method, it is possible to activate reactive sites of the resin in the resist underlayer film and promote the curing reaction performed by plasma irradiation.

Alternatively, in the step (i-1) and step (ii-1), the heat treatment can be performed under an atmosphere having an oxygen concentration of less than 1%.

As the atmosphere during the baking, it is possible to select, as necessary, an oxygen-containing atmosphere (oxygen concentration: 1% to 21%), such as air, or a non-oxygen atmosphere, such as nitrogen. For example, in a case where the substrate to be processed easily undergoes air oxidation, damage to the substrate can be suppressed by performing the heat treatment in an atmosphere with an oxygen concentration of less than 1% to form a cured film.

In the step (i-1) and step (ii-1), plasma irradiation may be performed after baking the resist underlayer film. The plasma irradiation step is as described later.

In the inventive patterning process, plasma irradiation may be performed in multiple steps: after forming the resist underlayer film; and after forming the resist underlayer film pattern. According to the above-described method, the modification of the resist underlayer film pattern can be further promoted.

### [Step (i-2)]

Step (i-2) is a step of forming a silicon-containing resist middle layer film on the resist underlayer film.

### <Silicon-Containing Resist Middle Layer Film>

The silicon-containing resist middle layer film (silicon-containing coating-type middle layer film) used in the inventive patterning process is not particularly limited. As the silicon-containing middle layer film usable here, many are known. However, in the present invention, in a case where the resist underlayer film pattern is achieved by the silicon-containing resist middle layer film remaining on the resist underlayer film, the residue of the dry-etched silicon-containing film and the resist underlayer film need to be washed and removed with a peeling solution simultaneously. Therefore, the silicon content in the silicon-containing resist middle layer film is preferably 45 mass% or less, more preferably 40 mass% or less, and particularly preferably 35 mass% or less.

Furthermore, the silicon-containing resist middle layer film is preferably formed from a silicon-containing resist middle layer film composition containing a compound having a crosslinkable organic structure.

When the silicon-containing resist middle layer film is as described, it can be removed simultaneously with the resist underlayer film more certainly by washing with a peeling solution after dry etching.

In this event, the crosslinkable organic structure is preferably one or more selected from an oxirane ring, an oxetane ring, a hydroxy group, and a carboxy group.

When the crosslinkable organic structure is as described, the silicon-containing resist middle layer film can be removed simultaneously with the resist underlayer film even more certainly by washing with a peeling solution after dry etching.

Furthermore, the composition for forming a silicon-containing resist middle layer film preferably further contains an acid generator that generates an acid by heat, light, or both.

Furthermore, the composition for forming a silicon-containing resist middle layer film preferably further contains a crosslinking agent.

When the composition for forming a silicon-containing resist middle layer film is as described, the crosslinking of the oxirane ring, oxetane ring, hydroxy group, carboxy group, etc. contained as the crosslinkable organic structure can be promoted, and it is possible to form a silicon-containing resist middle layer film that can be washed and removed simultaneously with the resist underlayer film with certainty even after dry etching.

Such a composition for forming a silicon-containing resist middle layer film and resin used for the composition are not particularly limited, and examples include resins and compositions disclosed in JP2004-310019A, JP2005-15779A, JP2005-18054A, JP2005-352104A, JP2007-226170A, etc.

Specific examples of the resin contained in the composition for forming a silicon-containing resist middle layer film used in the present invention include polysiloxanes containing one or more of a compound represented by the following general formula (A-1), a hydrolysis product thereof, a condensate thereof, and a hydrolysis condensate thereof.

R^{1A}_{A1}R^{2A}_{A2}R^{3A}_{A3}Si(OR^{0A})_{(4-A1-A2-A3)} (A-1)

In the formula, R^{0A} represents a hydrocarbon group having 1 to 6 carbon atoms; and R^{1A}, R^{2A}, and R^{3A} each represent a hydrogen atom or a monovalent organic group. A1, A2, and A3 each represent 0 or 1, provided that 0 ≤ A1+A2+A3 ≤ 3.

Examples of the organic groups represented by R^{1A,} R^{2A}, and R^{3A} include organic groups having one or more carbon-oxygen single bonds or carbon-oxygen double bonds. Specific examples include organic groups having one or more groups selected from the group consisting of an oxirane ring, an oxetane ring, an ester bond, an alkoxy group, and a hydroxy group. Examples thereof include those represented by the following general formula (A-2).

(P-Q₁-(S₁)ᵥ₁-Q₂-)ᵤ-(T)ᵥ₂-Q₃-(S₂)ᵥ₃-Q₄- (A-2)

In the general formulae (A-2), P represents a hydrogen atom, an oxirane ring, an oxetane ring, a hydroxy group, an alkoxy group having 1 to 4 carbon atoms, an alkylcarbonyloxy group having 1 to 6 carbon atoms, or an alkylcarbonyl group having 1 to 6 carbon atoms; Q₁, Q₂, Q₃, and Q₄ each independently represent - CqH(2q-p)Pp- (in the formula, P being as defined above, "p" representing an integer of 0 to 3, and "q" representing an integer of 0 to 10, provided that q=0 indicates a single bond); "u" represents an integer of 0 to 3; and S₁ and S₂ each independently represent -O-, - CO-, -OCO-, -COO-, or -OCOO-. "v1", "v2", and "v3" each independently represent 0 or 1. In addition, T represents a divalent group including an aliphatic ring or aromatic ring optionally containing a heteroatom, an oxirane ring, or an oxetane ring, and examples of the aliphatic ring or aromatic ring of the T, optionally containing a heteroatom, such as an oxygen atom, are shown below. In T, positions bonded to Q₂ and Q₃ are not particularly limited, and can be selected appropriately in consideration of reactivity dependent on steric factors, availability of commercial reagents used in the reaction, and so on.

### [Step (ii-2)]

Step (ii-2) is a step of forming an inorganic hard mask middle layer film selected from a silicon oxide film, a silicon nitride film, and a silicon oxynitride film on the resist underlayer film.

### <Inorganic Hard Mask Middle Layer Film>

When the inorganic hard mask middle layer film is formed on the resist underlayer film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask middle layer film is preferably 5 to 200 nm, more preferably 10 to 100 nm. The SiON film, which has a high function as an antireflective film, is the most preferably used as the inorganic hard mask middle layer film. Since the substrate temperature increases to 300 to 500°C when the SiON film is formed, the resist underlayer film needs to withstand a temperature of 300 to 500°C. The composition for forming a resist underlayer film used in the present invention has high heat resistance and can withstand a high temperature of 300 to 500°C. Thus, the resist underlayer film formed by spin-coating and the inorganic hard mask middle layer film formed by the CVD method or the ALD method can be combined.

A photoresist film may be formed on the inorganic hard mask middle layer film as the resist upper layer film. Alternatively, an organic antireflective film (BARC) or an adhesive film may be formed on the inorganic hard mask middle layer film by spin-coating, and a photoresist film may be formed thereon. In particular, when a SiON film is used as the inorganic hard mask middle layer film, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

### [Steps (i-3) and (ii-3)]

Steps (i-3) and (ii-3) are steps of forming a resist upper layer film.

### <Resist Upper Layer Film>

Resist upper layer films usable for the inventive patterning processes are not particularly limited, and any of the various resist films conventionally known can be used.

In the above-described patterning processes, the resist upper layer film may be either a positive type or a negative type, and it is possible to use a film similar to the typically used photoresist composition. In addition, the photoresist composition may contain a metal atom of Sn, In, Ga, Ge, Al, Ce, La, Cs, Zr, Hf, Ti, Bi, Sb, Zn, etc. In a case where the resist upper layer film is formed with the photoresist composition, a spin-coating method may be employed, or the film may be formed by a deposition treatment according to CVD or ALD.

In a case where the photoresist composition is formed by a spin-coating method, prebaking is conducted after applying the resist. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

In a case where the resist upper layer film is to be formed by a deposition treatment according to CVD or ALD, the resist composition is a metal oxide film having photosensitivity to EUV, and the metal is selected from Sn, Zr, Hf, Ti, Bi, Sb, etc. In particular, Sn, which has excellent photosensitivity to EUV, is preferable. The metal-oxide-containing film may be a photosensitive organometallic oxide film such as an organotin oxide (for example, haloalkyl Sn, alkoxyalkyl Sn, or amidoalkyl Sn). Some specific examples of suitable precursors include trimethyl tin chloride, dimethyltin dichloride, methyltin trichloride, tris(dimethylamino)methyl tin(IV), and (dimethylamino)trimethyl tin(IV).

The metal oxide film may be deposited by PECVD or PEALD, for example, by using a Lam Vector (registered trademark) tool, separating the Sn oxide precursor from O precursor/plasma in the ALD implementation. Deposition temperature is preferably 50°C to 600°C. Deposition pressure is preferably between 100 and 6,000 mTorr. Precursor liquid flow rates for metal oxide-containing film (e.g., an organotin oxide precursor) can be 0.01 to 10 cmm, and gas flow rates (CO₂, CO, Ar, and N₂) can be 100 to 10,000 sccm. Plasma powers can be 200 to 1,000 W per 300 mm wafer station, using a highfrequency plasma (e.g., 13.56 MHz, 27.1 MHz, or higher). Deposited thickness is preferably 100 to 2,000 Å.

<Water-Repellent Coating Film>

When the resist upper layer film pattern is formed, if a top coat for the resist upper layer film is necessary for using liquid immersion exposure, a water-repellent coating film may be further formed on the resist upper layer film. The water-repellent coating film is not particularly limited, and various films can be used.

### [Steps (i-4) and (ii-4)]

Steps (i-4) and (ii-4) are steps of subjecting the resist upper layer film to pattern exposure and then development with a developer to form a pattern in the resist upper layer film.

Examples of light for exposure include high-energy beams at wavelengths of 300 nm or less, specifically 248 nm and 193 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

### [Steps (i-5) and (ii-5)]

Steps (i-5) and (ii-5) are steps of forming a resist underlayer film pattern by etching multiple times while using the pattern of the resist upper layer film as a mask.

Steps (i-5) and (ii-5) are steps of: transferring the resist upper layer film pattern to the silicon-containing middle layer film or inorganic hard mask middle layer film by dry etching while using the resist upper layer film having the formed resist upper layer film pattern as a mask; and further transferring the resist upper layer film pattern to the resist underlayer film by dry etching while using the silicon-containing resist middle layer film or inorganic hard mask middle layer film having the transferred resist upper layer film pattern as a mask to form a resist underlayer film pattern.

In steps (i-5) and (ii-5), when the etching of the silicon-containing resist middle layer film or inorganic hard mask middle layer film is performed under dry etching conditions where the etching rate of the silicon-containing resist middle layer film and inorganic hard mask middle layer film is higher than that of the resist upper layer film pattern, for example, by dry etching with a fluorine-based gas plasma, while using the pattern of the resist upper layer film as an etching mask, the pattern of the resist upper layer film can be transferred to the silicon-containing resist middle layer film or inorganic hard mask middle layer film almost without being affected by change in the pattern caused by side-etching of the resist film.

Subsequently, the resist underlayer film is etched under dry etching conditions where the etching rate of the resist underlayer film is higher than that of the silicon-containing resist middle layer film or inorganic hard mask middle layer film having the transferred resist upper layer film pattern, for example, by reactive dry etching using gas plasma containing oxygen or by reactive dry etching using gas plasma containing hydrogen-nitrogen.

The resist underlayer film pattern is obtained by this etching step. At the same time, the uppermost resist layer is usually lost, but part of the silicon-containing resist middle layer film or inorganic hard mask middle layer film used as an etching mask may be allowed to remain on top of the resist underlayer film pattern as described later.

Furthermore, in steps (i-5) and (ii-5), the resist underlayer film pattern may be the resist underlayer film on which the silicon-containing resist middle layer film or inorganic hard mask middle layer film remains.

Alternatively, in steps (i-5) and (ii-5), the resist underlayer film pattern may also be the resist underlayer film on which the silicon-containing resist middle layer film or inorganic hard mask middle layer film does not remain.

In the inventive patterning process, an inorganic silicon film pattern (sidewall pattern) can be formed without damaging the sidewall or substrate either in a case where there is a residue of the material to be a mask after pattern transfer by dry etching or in a case where there is no such residue.

Note that the pattern transfer of a multilayer resist by dry etching actually applied in the manufacturing process of a semiconductor device is often performed under conditions where part of the pattern material to be a mask is left on top of a transferred pattern in order to ensure the rectangularity of the pattern profile after dry etching. That is, the step may be allowed to proceed under conditions where part of the resist upper layer film remains when the pattern is transferred to the silicon-containing resist middle layer film by dry etching while using the resist upper layer film as a mask in order to ensure the rectangularity of the cross-sectional profile of the silicon-containing resist middle layer film pattern in the inventive patterning process as well. In the same manner, when the pattern is subsequently transferred to the resist underlayer film while using the silicon-containing resist middle layer film as a mask, it is possible to allow the pattern transfer step to proceed in a state where part of the silicon-containing resist middle layer film or inorganic hard mask middle layer film remains on top of the resist underlayer film in order to ensure the rectangularity of the cross-sectional profile of the resist underlayer film pattern. Then, a sidewall spacer method is to be performed using the resist underlayer film pattern as a core material, that is, after a sidewall is formed with the inorganic silicon film, the resist underlayer film pattern is to be removed to form an inorganic silicon film pattern. However, if it is attempted to remove the silicon-containing resist middle layer film residue or inorganic hard mask middle layer film residue remaining on top of the resist underlayer film pattern by dry etching, the sidewall formed with the inorganic silicon film and the substrate are damaged by the dry etching, and problems of the performance degradation of the product and reduction in yield occur. Accordingly, in the inventive patterning processes, it is preferable to prevent such problems from occurring by performing a wet treatment with a peeling solution and removing the silicon-containing resist middle layer film as described below.

When the silicon-containing resist middle layer film is removed with a peeling solution, the peeling solution is not particularly limited as long as it is a solution such as a basic solution or an acidic solution.

As acid-containing removers, there is no particular limitation as long as they are acidic solutions containing an acid, but a solution containing any one or two out of hydrogen fluoride, hydrogen peroxide, and sulfuric acid is preferable. More specifically, particularly preferable are: an aqueous solution containing hydrochloric acid and hydrogen peroxide (SC-2 chemical solution); an aqueous solution containing sulfuric acid and hydrogen peroxide (SPM chemical solution); and an aqueous solution containing hydrofluoric acid and hydrogen peroxide (FPM chemical solution).

As base-containing removers, there is no particular limitation as long as they are basic solutions containing a base. Examples of the base include sodium hydroxide, potassium hydroxide, sodium carbonate, sodium silicate, sodium metasilicate, ammonia, ethylamine, n-propylamine, diethylamine, di-n-propylamine, triethylamine, methyldiethylamine, dimethylethanolamine, triethanolamine, tetramethylammonium hydroxide (hereinafter also referred to as "TMAH"), tetraethylammonium hydroxide, pyrrole, piperidine, choline, 1,8-diazabicyclo[5.4.0]-7-undecene, and 1,5-diazabicyclo-[4.3.0]-5-nonene. Among these, from the viewpoint of avoiding damage to the substrate, tetramethylammonium hydroxide (hereinafter also referred to as "TMAH") or ammonia is preferable.

As the base-containing removers, a solution containing a base and water or a solution containing a base, hydrogen peroxide, and water is preferable. More specifically, particularly preferable are mixed aqueous solutions of ammonia and hydrogen peroxide (a mixed aqueous solution in which 25% aqueous ammonia solution/30% hydrogen peroxide solution/water = 1/2/40, a mixed aqueous solution in which 25% aqueous ammonia solution/30% hydrogen peroxide solution/water = 1/1/5, etc. (SC1)).

To promote the peeling, it is further preferable to adjust the pH by adding an acid or an alkali. Examples of this pH adjuster include: inorganic acids, such as hydrochloric acid and sulfuric acid; organic acids, such as acetic acid, oxalic acid, tartaric acid, citric acid, and lactic acid; nitrogen-containing alkalis, such as ammonia, ethanolamine, and tetramethylammonium hydroxide; nitrogen-containing organic acid compounds, such as EDTA (ethylenediaminetetraacetic acid); etc.

The peeling solution is usually an aqueous solution, but an organic solvent may be contained depending on the circumstances. Examples of the organic solvent include water-soluble alcohols, ethers, ketones, esters, amides, and imides. Specific examples include methanol, ethanol, propanol, butanol, ethylene glycol, propylene glycol, diethylene glycol, dipropylene glycol, ethylene glycol methyl ether, ethylene glycol dimethyl ether, ethylene glycol ethyl ether, diethylene glycol methyl ether, diethylene glycol dimethyl ether, diethylene glycol ethyl ether, diethylene glycol diethyl ether, propylene glycol methyl ether, propylene glycol dimethyl ether, propylene glycol ethyl ether, propylene glycol ethyl ether, dipropylene glycol methyl ether, dipropylene glycol dimethyl ether, dipropylene glycol ethyl ether, dipropylene glycol diethyl ether, tetrahydrofuran, tetrahydrofurfuryl alcohol, acetone, methyl ethyl ketone, ethyl lactate, N-methylpyrrolidinone, N,N-dimethylformamide, and N,N-dimethylacetamide.

Methods for performing wet peeling are not particularly limited as long as the silicon wafer on which the substrate to be processed is formed and a peeling chemical solution can be in contact for a certain period under heating conditions. Examples include: a method of immersing the silicon wafer on which the substrate to be processed is formed in a heated alkaline hydrogen peroxide solution; a method of spraying an alkaline hydrogen peroxide solution in a heated environment; and a method of applying a heated alkaline hydrogen peroxide solution. After each of these methods, it is preferable to wash the substrate with water and dry the substrate.

The lower limit of the temperature of the wet peeling is preferably 23°C, preferably 40°C, and more preferably 50°C. The upper limit of the temperature is preferably 100°C, more preferably 90°C.

The lower limit of the immersion time in the immersion method is preferably 1 second, more preferably 10 seconds, further preferably 20 seconds, and particularly preferably 30 seconds. The upper limit of the immersion time is preferably 60 minutes, more preferably 30 minutes, further preferably 20 minutes, and particularly preferably 10 minutes from the viewpoint of suppressing influence on the substrate.

The removal of the silicon-containing resist middle layer film remaining on the resist underlayer film pattern performed by using a peeling solution may be performed before plasma irradiation or after plasma irradiation.

When the silicon-containing resist middle layer film is removed before plasma irradiation, it is possible to modify the edge roughness of the resist underlayer film pattern, which is degraded by wet peeling, by the plasma irradiation.

When the silicon-containing resist middle layer film is removed after plasma irradiation, the resistance of the resist underlayer film pattern to a peeling solution is enhanced, and therefore, it is possible to suppress the degradation of the edge roughness of the resist underlayer film pattern caused by the wet peeling. The resistance of the resist underlayer film pattern to a peeling solution is enhanced by plasma irradiation, and therefore, the wet peeling of the silicon-containing resist middle layer film is more preferably performed after the plasma irradiation of the resist underlayer film pattern.

### [Steps (i-6) and (ii-6)]

Steps (i-6) and (ii-6) are steps of subjecting the resist underlayer film pattern to plasma irradiation.

For the plasma irradiation in the step (i-6) and the step (ii-6), a known method can be used. Examples include methods disclosed in JP5746670B2 and "Improvement of the wiggling profile of spin-on carbon hard mask by H₂ plasma treatment" (J. Vac. Sci. Technol. B26 (1), Jan/Feb 2008, p67-71).

In the step (i-6) and the step (ii-6), it is necessary to use, as the plasma used for the plasma irradiation, a plasma that etches the resist underlayer film less than an etching gas used in the step (i-5) and the step (ii-5) of forming the resist underlayer film pattern by etching the resist underlayer film.

RF discharge power is preferably 100 to 10,000 W, more suitably 500 to 5,000 W.

Examples of the gas atmosphere include N₂, NF₃, H₂, rare gases such as He, and fluorocarbon; and more suitable examples include He, Ar, N₂, Ne, NF₃, H₂, CF₄, CHF₃, CH₂F₂, CH₃F, C₄F₆, C₄F_{B}, etc. These gases may be used as a mixture of two or more kinds. An advantage of the present invention is that the advantageous effects of the present invention can be expected even when using a gas atmosphere not containing O₂.

The time of the plasma irradiation can be selected from, for example, 10 to 240 seconds. The pressure can be selected appropriately.

In the steps (i-6) and (ii-6), the plasma irradiation is preferably performed under an atmosphere of N₂, NF₃, H₂, fluorocarbon, a rare gas such as He, or a mixture of any thereof.

From the viewpoint of productivity, examples of particularly favorable gas atmospheres include He, Ar, N₂, H₂, etc., and a gas containing H₂ or helium is preferable.

After the plasma irradiation, the resist underlayer film may be subjected to heat treatment. When heating is to be performed after the plasma irradiation, as the heating conditions, the heating temperature can be selected appropriately from the range of 80 to 800°C (preferably 100 to 700°C, more preferably 200 to 600°C), and the heating time from the range of 30 to 180 seconds (preferably 30 to 120 seconds). Although not bound by the theory, it is considered that, by performing high-temperature heating after the plasma irradiation, dangling bonds are bonded, and this can contribute to higher density of the cured film (resist underlayer film).

As the atmosphere during the heating after the plasma irradiation, it is possible to select, as necessary, an oxygen-containing atmosphere (oxygen concentration: 1% to 21%), such as air, or a non-oxygen atmosphere, such as nitrogen. For example, in a case where the substrate to be processed easily undergoes air oxidation, damage to the substrate can be suppressed by performing the heat treatment in an atmosphere with an oxygen concentration of less than 1% to form a cured film.

The irradiation apparatus is not particularly limited as long as plasma irradiation can be performed with the apparatus, and for example, it is possible to use Telius SP or Tactras Vigus manufactured by Tokyo Electron Ltd. It is possible to select an apparatus and set conditions in such a manner as to achieve the advantageous effects of the present invention more prominently.

The design of the resist underlayer film pattern is not particularly limited. Examples include a line pattern and a contact hole pattern, and from the viewpoint of the uniformity of the surface modification by the plasma irradiation, a line pattern is preferable. Therefore, the resist underlayer film patterning process of the present invention can be used suitably for a sidewall spacer method.

To promote the modification of the resist underlayer film pattern by the plasma irradiation, the thickness of the silicon-containing resist middle layer film or inorganic hard mask middle layer film remaining on the resist underlayer film pattern is preferably thin. The thickness of the silicon-containing resist middle layer film or inorganic hard mask middle layer film remaining on the resist underlayer film pattern is preferably 15 nm or less, more preferably 10 nm or less, further preferably 5 nm or less, and such a film may not be present on the resist underlayer film pattern.

The patterning process preferably includes, after the step of performing plasma irradiation, a step of forming the pattern directly or indirectly on the substrate while using the plasma-irradiated resist underlayer film pattern as an etching mask.

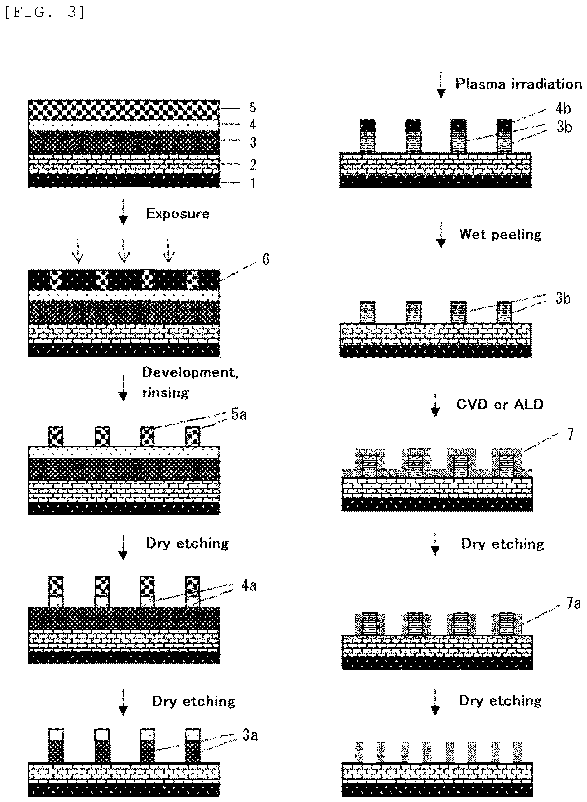

Meanwhile, the present invention may also be a patterning process for forming a half-pitch pattern of the pattern of the resist upper layer film on the substrate to be processed (FIG. 3), the patterning process including,
after the step of subjecting the resist underlayer film pattern to plasma irradiation, the steps of:
forming an inorganic silicon film including any of polysilicon, amorphous silicon, silicon oxide, silicon nitride, silicon oxynitride, silicon carbide, and composite materials thereof by a CVD method or an ALD method to cover the resist underlayer film pattern;
removing the resist underlayer film pattern by dry etching to form an inorganic silicon film pattern having a half pitch of the pattern of the resist upper layer film; and
forming a half-pitch pattern of the pattern of the resist upper layer film on the substrate to be processed while using the inorganic silicon film pattern as a mask.

Such a patterning process makes it possible to form an inorganic silicon film pattern (sidewall pattern) having small edge roughness in a sidewall spacer method, and is therefore extremely useful in a fine processing process.

The removal of the resist underlayer film pattern is not particularly limited, but from the viewpoint of preventing the inorganic silicon film pattern (sidewall pattern) from collapsing, removal by dry etching is preferable.

When removal by dry etching is selected, the resist underlayer film is removed under dry etching conditions where the etching rate of the resist underlayer film is higher than that of the sidewall pattern, for example, by reactive dry etching using gas plasma containing oxygen or by reactive dry etching using gas plasma containing hydrogen-nitrogen.

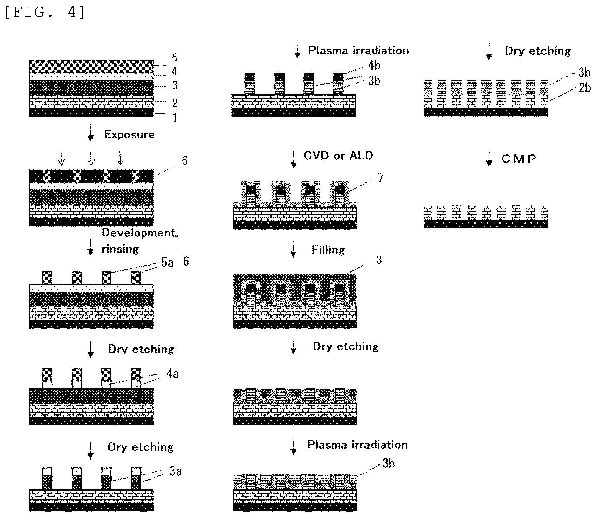

Alternatively, the present invention may also be a patterning process for forming a half-pitch pattern of the pattern of the resist upper layer film on the substrate to be processed (FIG. 4), the patterning process including,
after the step of subjecting the resist underlayer film pattern to plasma irradiation, the steps of:
forming an inorganic silicon film including any of polysilicon, amorphous silicon, silicon oxide, silicon nitride, silicon oxynitride, silicon carbide, and composite materials thereof by a CVD method or an ALD method to cover the resist underlayer film pattern;
applying the composition for forming a resist underlayer film of the present invention to be modified by plasma irradiation onto the inorganic silicon film pattern for pattern separation, followed by heating;
exposing the inorganic silicon film pattern by etching back, followed by plasma irradiation;
removing the inorganic silicon film pattern by dry etching to form a resist underlayer film pattern having a half pitch of the pattern of the resist upper layer film; and
forming a half-pitch pattern of the pattern of the resist upper layer film on the substrate to be processed while using the resist underlayer film pattern as a mask.

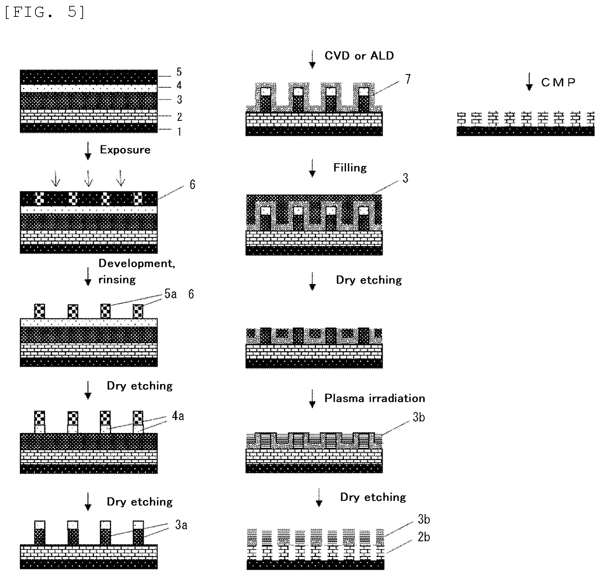

Alternatively, the present invention may also be a patterning process for forming a half-pitch pattern of the pattern of the resist upper layer film on the substrate to be processed (FIG. 5), the patterning process including,
before the step of subjecting the resist underlayer film pattern to plasma irradiation, the steps of:
forming an inorganic silicon film including any of polysilicon, amorphous silicon, silicon oxide, silicon nitride, silicon oxynitride, silicon carbide, and composite materials thereof by a CVD method or an ALD method to cover the resist underlayer film pattern;
applying the composition for forming a resist underlayer film of the present invention to be modified by plasma irradiation onto the inorganic silicon film pattern for pattern separation, followed by heating;
exposing the inorganic silicon film pattern by etching back, followed by plasma irradiation;
removing the inorganic silicon film pattern by dry etching to form a resist underlayer film pattern having a half pitch of the pattern of the resist upper layer film; and
forming a half-pitch pattern of the pattern of the resist upper layer film on the substrate to be processed while using the resist underlayer film pattern as a mask.

Methods for removing the resist underlayer film pattern and inorganic silicon film pattern that remain on the substrate to be processed are not particularly limited, and the patterns can be removed by a CMP method or the like, for example.

### EXAMPLES

Hereinafter, the present invention will be specifically described with reference to Examples and Comparative Examples, but the present invention is not limited thereto.

The present invention is more specifically described below with reference to Synthesis Examples, Comparative Synthesis Examples, Examples, and Comparative Examples. However, the present invention is not limited to these Examples. To obtain molecular weight and dispersity, weight-average molecular weight (Mw) and number-average molecular weight (Mn) on polystyrene basis were measured by gel permeation chromatography (GPC) using tetrahydrofuran as an eluent, and dispersity (Mw/Mn) was calculated from these values.

For the synthesis of compounds (A1) to (A14) and comparative compound (R1), the following compounds (G1) to (G13) were used.

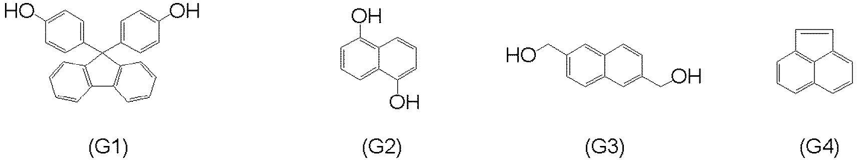

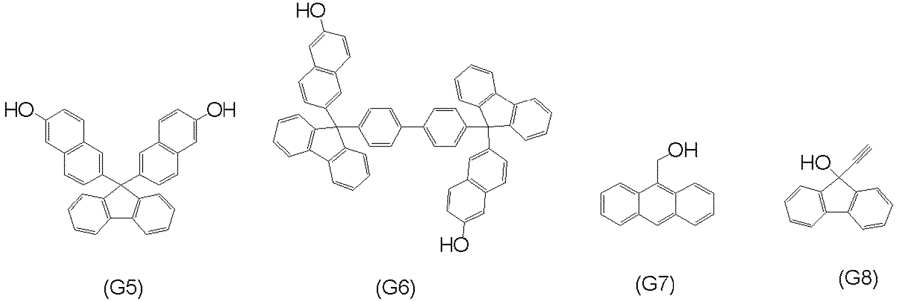

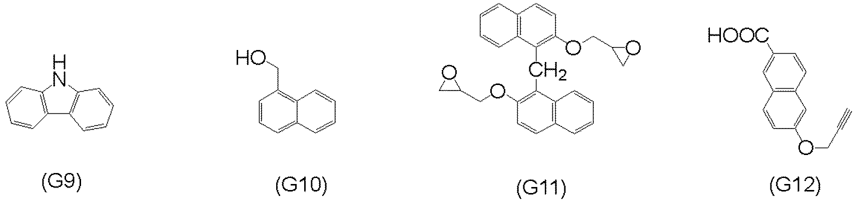

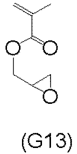

### [Synthesis Example 1] Synthesis of Compound (A1)

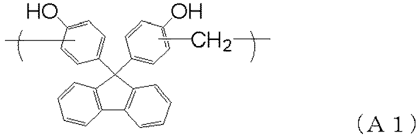

Under a nitrogen atmosphere, 180 g of the compound (G1), 75 g of a 37% formalin solution, and 5 g of oxalic acid were added together and then stirred at an internal temperature of 100°C for 24 hours. After cooling to room temperature, 500 g of methyl isobutyl ketone was added thereto. The organic layer was washed five times with 200 g of pure water, and then the organic layer was evaporated under reduced pressure to dryness. To the residue, 320 g of THF was added, and the polymer was reprecipitated in 1350 g of hexane. The precipitated polymer was separated by filtration and dried under reduced pressure to obtain a compound (A1).

The weight-average molecular weight (Mw) and the dispersity (Mw/Mn) were determined by GPC, and the following results were obtained.
(A1): Mw=11,200, Mw/Mn=4.35

### [Synthesis Example 2] Synthesis of Compound (A2)

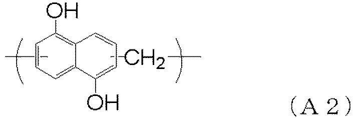

Under a nitrogen atmosphere, 160.2 g of the compound (G2), 64.9 g of a 37% formaldehyde solution, and 300 g of 2-methoxy-1-propanol were added together and homogenized at an internal temperature of 100°C. After that, 18.0 g of a 20% solution of paratoluenesulfonic acid in 2-methoxy-1-propanol, which had been mixed and homogenized beforehand, was slowly added thereto, and the reaction was allowed to take place at an internal temperature of 80°C for 8 hours. After the reaction was completed, the product was cooled to room temperature, 1000 ml of methyl isobutyl ketone was added thereto, the obtained product was washed six times with 200 ml of pure water, and the organic layer was evaporated under reduced pressure to dryness. To the residue, 300 g of THF was added to form a homogeneous solution, and a crystal was precipitated in 2000 g of hexane. The precipitated crystal was separated by filtration, washed twice with 500 g of hexane, and collected. The collected crystal was vacuum-dried at 70°C to obtain a compound (A2).

The weight-average molecular weight (Mw) and the dispersity (Mw/Mn) were determined by GPC, and the following results were obtained.
(A2): Mw=4,000, Mw/Mn=3.02

### [Synthesis Example 3] Synthesis of Compound (A3)

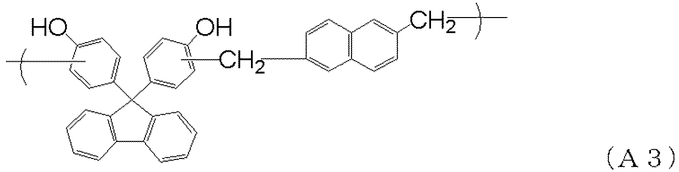

Under a nitrogen atmosphere, 100.0 g of the compound (G1), 48.3 g of the compound (G3), and 450 g of 1,2-dichloroethane were mixed together and then homogeneously dispersed at an internal temperature of 60°C. Subsequently, 82.4 g of methanesulfonic acid was added dropwise thereto over 1 hour, and the mixture was heated and stirred at an internal temperature of 70°C for 24 hours. After cooling to room temperature, 1000 g of methyl isobutyl ketone was added thereto. The organic layer was washed five times with 200 g of pure water, and then the organic layer was evaporated under reduced pressure to dryness. To the residue, 450 g of THF was added, and the polymer was reprecipitated in 1800 g of hexane. The precipitated polymer was separated by filtration and dried under reduced pressure to obtain a compound (A3).

The weight-average molecular weight (Mw) and the dispersity (Mw/Mn) were determined by GPC, and the following results were obtained.
(A3): Mw=9,800, Mw/Mn=3.50

### [Synthesis Example 4] Synthesis of Compound (A4)

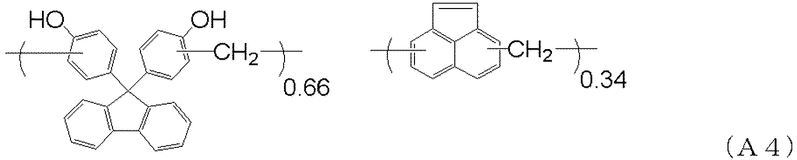

Under a nitrogen atmosphere, 180.0 g of the compound (G1), 58.0 g of the compound (G4), 75.0 g of a 37% formalin solution, 5.0 g of oxalic acid, and 500 g of 2-methoxy-1-propanol were added together and then stirred at an internal temperature of 100°C for 24 hours. After cooling to room temperature, 1000 g of methyl isobutyl ketone was added thereto. The organic layer was washed five times with 200 g of pure water, and then the organic layer was evaporated under reduced pressure to dryness. To the residue, 480 g of THF was added, and the polymer was reprecipitated in 2400 g of hexane. The precipitated polymer was separated by filtration and dried under reduced pressure to obtain a compound (A4).

The weight-average molecular weight (Mw) and the dispersity (Mw/Mn) were determined by GPC, and the following results were obtained.
(A4): Mw=9,350, Mw/Mn=3.76

### [Synthesis Example 5] Synthesis of Compound (A5)

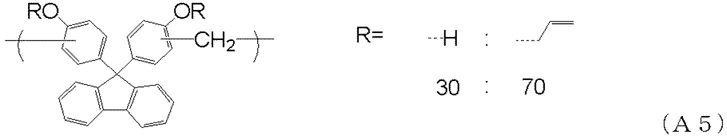

Under a nitrogen atmosphere, 50.0 g of the compound (A1) obtained in Synthesis Example 1, 38.1 g of potassium carbonate, and 200 g of dimethylformamide were added together to form a homogeneous dispersion at 50°C. Subsequently, 23.4 g of allyl bromide was slowly added dropwise thereto, and the mixture was stirred at an internal temperature of 50°C for 8 hours. The reaction solution was cooled to room temperature, and 400 ml of methyl isobutyl ketone and 300 g of pure water were added thereto. The precipitated salt was dissolved, and then the separated aqueous layer was removed. Furthermore, the organic layer was washed six times with 100 g of a 3% aqueous solution of nitric acid and 100 g of pure water, and then the organic layer was evaporated under reduced pressure to dryness to obtain a compound (A5).

The weight-average molecular weight (Mw) and the dispersity (Mw/Mn) were determined by GPC, and the following results were obtained.
(A5): Mw=12,200, Mw/Mn=4.38

### [Synthesis Example 6] Synthesis of Compound (A6)

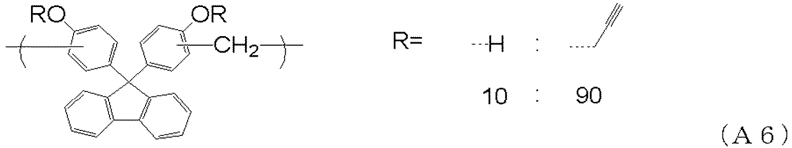

Under a nitrogen atmosphere, 50.0 g of the compound (A1) obtained in Synthesis Example 1, 41.9 g of potassium carbonate, and 200 g of dimethylformamide were added together to form a homogeneous dispersion at 50°C. Subsequently, 29.5 g of 3-bromo-1-propyne was slowly added dropwise thereto, and the mixture was stirred at an internal temperature of 50°C for 8 hours. The reaction solution was cooled to room temperature, and 400 ml of methyl isobutyl ketone and 300 g of pure water were added thereto. The precipitated salt was dissolved, and then the separated aqueous layer was removed. Furthermore, the organic layer was washed six times with 100 g of a 3% aqueous solution of nitric acid and 100 g of pure water, and then the organic layer was evaporated under reduced pressure to dryness to obtain a compound (A6).

The weight-average molecular weight (Mw) and the dispersity (Mw/Mn) were determined by GPC, and the following results were obtained.
(A6): Mw=12,800, Mw/Mn=4.43

### [Synthesis Example 7] Synthesis of Compound (A7)

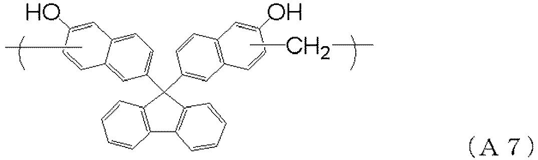

Under a nitrogen atmosphere, 90.1 g of the compound (G5), 25.2 g of a 37% formalin solution, and 270 g of 2-methoxy-1-propanol were added together to form a homogeneous solution at an internal temperature of 80°C. Subsequently, 18 g of a 20% solution of paratoluenesulfonic acid in 2-methoxy-1-propanol was slowly added thereto, and the mixture was stirred at an internal temperature of 110°C for 8 hours. After cooling to room temperature, 600 g of methyl isobutyl ketone was added thereto. The organic layer was washed five times with 200 g of pure water, and then the organic layer was evaporated under reduced pressure to dryness. To the residue, 320 g of THF was added, and the polymer was reprecipitated in 1350 g of methanol. The precipitated polymer was separated by filtration and dried under reduced pressure to obtain a compound (A7).

The weight-average molecular weight (Mw) and the dispersity (Mw/Mn) were determined by GPC, and the following results were obtained.
(A7): Mw=3,520, Mw/Mn=2.60

### [Synthesis Example 8] Synthesis of Compound (A8)

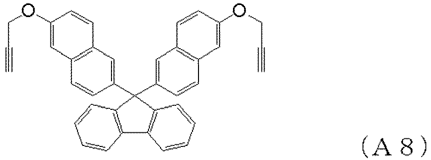

Under a nitrogen atmosphere, 42.8 g of the compound (G5), 15.7 g of potassium carbonate, and 150 g of DMF were added together to form a homogeneous dispersion at an internal temperature of 50°C. 28.2 g of propargyl bromide was slowly added thereto, and the reaction was allowed to take place at an internal temperature of 50°C for 24 hours. To the reaction solution, 300 ml of methyl isobutyl ketone and 300 g of pure water were added. The precipitated salt was dissolved, and then the separated aqueous layer was removed. Furthermore, the organic layer was washed six times with 100 g of a 3% aqueous solution of nitric acid and 100 g of pure water, and then the organic layer was evaporated under reduced pressure to dryness to obtain a compound (A8).

The weight-average molecular weight (Mw) and the dispersity (Mw/Mn) were determined by GPC, and the following results were obtained.
(A8): Mw=560, Mw/Mn=1.01

### [Synthesis Example 9] Synthesis of Compound (A9)

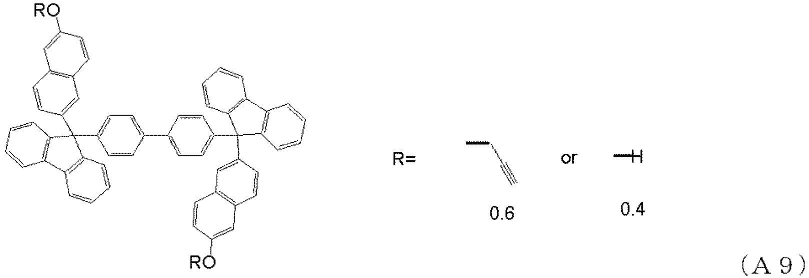

Under a nitrogen atmosphere, 46.9 g of the compound (G6), 10.1 g of potassium carbonate, and 150 g of DMF were added together to form a homogeneous dispersion at an internal temperature of 50°C. 9.0 g of propargyl bromide was slowly added thereto, and the reaction was allowed to take place at an internal temperature of 50°C for 24 hours. To the reaction solution, 300 ml of methyl isobutyl ketone and 300 g of pure water were added. The precipitated salt was dissolved, and then the separated aqueous layer was removed. Furthermore, the organic layer was washed six times with 100 g of a 3% aqueous solution of nitric acid and 100 g of pure water, and then the organic layer was evaporated under reduced pressure to dryness to obtain a compound (A9).

The weight-average molecular weight (Mw) and the dispersity (Mw/Mn) were determined by GPC, and the following results were obtained.
(A9): Mw=903, Mw/Mn=1.08

### [Synthesis Example 10] Synthesis of Compound (A10)

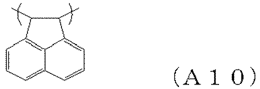

Under a nitrogen atmosphere, 3.8 g of methanesulfonic acid and 30 g of methylene chloride were mixed together and homogenized at an internal temperature of 30°C. Subsequently, a mixed solution of 30.0 g of the compound (G4) and 60.0 g of methylene chloride was added dropwise thereto over 1 hour, and the mixture was heated and stirred at an internal temperature of 35°C for 24 hours. After cooling to room temperature, 300 g of toluene was added thereto. The organic layer was washed six times with 100 g of pure water, and the organic layer was evaporated under reduced pressure to dryness. To the residue, 90 g of THF was added to obtain a homogeneous solution, and then a crystal was precipitated in 600 g of methanol. The precipitated crystal was separated by filtration, washed twice with 300 g of methanol, and collected. The collected crystal was vacuum-dried at 70°C to obtain 28.7 g of a compound (A10).

The weight-average molecular weight (Mw) and the dispersity (Mw/Mn) were determined by GPC, and the following results were obtained.
(A10): Mw=2400, Mw/Mn=1.93

### [Synthesis Example 11] Synthesis of Compound (A11)

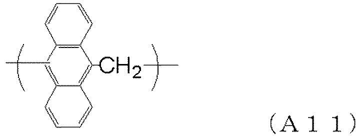

Under a nitrogen atmosphere, 60.0 g of the compound (G7) and 300 g of 1,2-dichloroethane were mixed together and homogeneously dispersed at an internal temperature of 60°C. Subsequently, 55.4 g of methanesulfonic acid was added dropwise thereto over 1 hour, and the mixture was heated and stirred at an internal temperature of 70°C for 6 hours. After cooling to room temperature, 400 g of 1,2-dichloroethane was added thereto, and then insoluble matter was removed by filtration. The collected filtrate was washed six times with 200 g of pure water, and the organic layer was evaporated under reduced pressure to dryness. To the residue, 150 g of THF was added to obtain a homogeneous solution, and then a crystal was precipitated in 500 g of methanol. The precipitated crystal was separated by filtration, washed with 300 g of methanol and 300 g of diisopropyl ether in this order, and collected. The collected crystal was vacuum-dried at 70°C to obtain 33.2 g of a compound (A111).

The weight-average molecular weight (Mw) and the dispersity (Mw/Mn) were determined by GPC, and the following results were obtained.
(A11): Mw=560, Mw/Mn=2.43

### [Synthesis Example 12] Synthesis of Compound (A12)

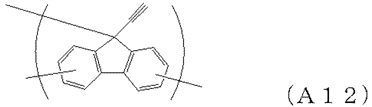

41.2 g of the tertiary alcohol (G8) and 160 g of methylene chloride were mixed together. 19.2 g of methanesulfonic acid was slowly added dropwise thereto, and the mixture was heated under reflux for 8 hours. After cooling to room temperature, 250 g of toluene was added thereto, and the product was washed with water and concentrated under reduced pressure to obtain 37.6 g of a compound (A12).

The weight-average molecular weight (Mw) and the dispersity (Mw/Mn) were determined by GPC, and the following results were obtained.
(A12): Mw=1850, Mw/Mn=1.26

### [Synthesis Example 13] Synthesis of Compound (A13)

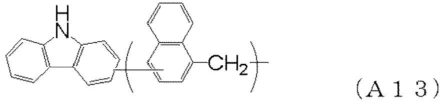

Under a nitrogen atmosphere, 60.0 g of the compound (G10), 6.3 g of the compound (G9), and 350 g of 1,2-dichloroethane were mixed together to form a homogeneous solution at an internal temperature of 60°C. Subsequently, 80.2 g of methanesulfonic acid was added dropwise thereto over 1 hour, and the mixture was heated and stirred at an internal temperature of 70°C for 6 hours. After cooling to room temperature, 200 g of 1,2-dichloroethane was added thereto, the organic layer was washed six times with 100 g of pure water, and the organic layer was evaporated under reduced pressure to dryness. To the residue, 200 g of THF was added to form a homogeneous solution, and then a crystal was precipitated in 600 g of methanol. The precipitated crystal was separated by filtration, washed with 300 g of methanol and 300 g of diisopropyl ether in this order, and collected. The collected crystal was vacuum-dried at 70°C to obtain 35.5 g of a compound (A13).

The weight-average molecular weight (Mw) and the dispersity (Mw/Mn) were determined by GPC, and the following results were obtained.
(A13): Mw=730, Mw/Mn=1.38

### [Synthesis Example 14] Synthesis of Compound (A14)

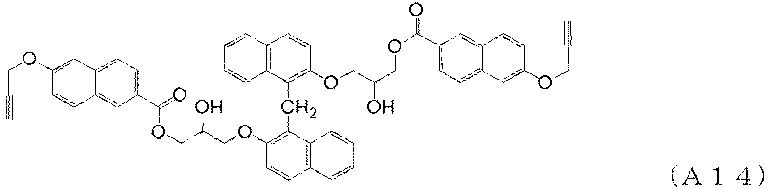

Under a nitrogen atmosphere, 80.0 g of the epoxy compound (G11), 51.0 g of the compound (G12), and 600 g of 2-methoxy-1-propanol were added together to form a homogeneous solution at 100°C. Subsequently, 5.7 g of benzyltriethylammonium chloride was added thereto, and the mixture was stirred at 120°C for 12 hours. After cooling to room temperature, 1,500 g of methyl isobutyl ketone was added thereto, and the organic layer was washed five times with 300 g of pure water. The organic layer was evaporated under reduced pressure to dryness to obtain a compound (A14).

The weight-average molecular weight (Mw) and the dispersity (Mw/Mn) were determined by GPC, and the following results were obtained.
(A14): Mw=900, Mw/Mn=1.04

### [Synthesis Example 15] Synthesis of Comparative Compound (R1)

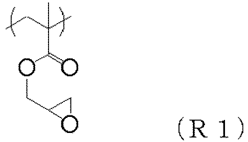

Into a 500-ml flask, 100 g of a monomer 1 (starting material G13) and 290.0 g of propylene glycol monomethyl ether acetate (hereinafter, written as "PGMEA") were measured and charged, and degassing was performed while stirring to prepare a monomer solution. Into a different 500-ml flask, 2.9 g of dimethyl 2,2'-azobis(2-methylpropionate) (V-601 available from Wako Pure Chemical Corporation) and 50.0 g of PGMEA were measured and charged, and degassing was performed while stirring to prepare an initiator solution. Furthermore, into a 1-L flask having a nitrogen atmosphere, 60 g of PGMEA was measured and charged, degassing was performed while stirring, and then the PGMEA was heated until the internal temperature was 80°C. The monomer solution and the initiator solution were added thereto simultaneously and separately over 4 hours. After the addition, the mixture was heated and stirred for 16 hours, and then cooled to room temperature. The obtained polymer solution was dropped into 1,500 g of stirred hexane, and the precipitated polymer was filtered. Furthermore, the obtained polymer was washed twice with 600 g of hexane, and then vacuum-dried at 50°C for 20 hours to obtain a polymer (R1) in white powder form.

The weight-average molecular weight (Mw) and the dispersity (Mw/Mn) were determined by GPC, and the following results were obtained.
(R1): Mw=10,000, Mw/Mn=2.00

### [Composition UDL-1 for Forming Resist Underlayer Film]

The compound (A1) for forming a resist underlayer film was dissolved at a ratio shown in Table 2 in propylene glycol monomethyl ether acetate (PGMEA) containing 0.5 mass% of a surfactant FC-4430 (available from Sumitomo 3M Limited), and the obtained solution was filtered through a 0.02-µm membrane filter to prepare a composition (UDL-1) for forming a resist underlayer film.

### [Preparation of Compositions (UDL-2 to -17) for Forming Resist Underlayer Film and Comparative Composition (Comparative UDL-1) for Forming Resist Underlayer Film]

Each chemical solution was prepared in the same manner as UDL-1, except that the kind and the contained amount of each component were as shown in Table 2. In Table 2, "-" indicates that the component was not used. The following formula (E1) was used for the acid generator (TAG), and the following formula (B1) was used for the flowability accelerator. The results for UDL-1 are also shown.

### [Acid Generator]

The thermal acid generator (E1) used in compositions for forming a resist underlayer film is shown below. 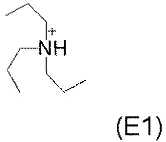 CF₃CF₂CF₂SO₃⁻

### [Flowability Accelerator]

The flowability accelerator (B1) used in a composition for forming a resist underlayer film is shown in Table 1.

**[Table 1]**

| Compound or polymer | Mw (calculated value) | Weight reduction rate on heating from 30°C to 190°C | Weight reduction rate on heating from 30°C to 350°C |
|---|---|---|---|
| 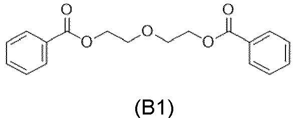 | 314 | 1 | 100 |

### [Crosslinking Agent]

The crosslinking agents (C) used in resist underlayer film materials are shown below.

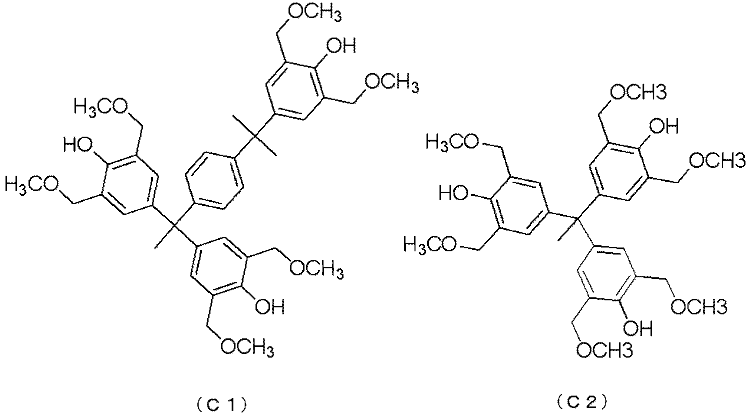

**[Table 2]**

| Composition for forming resist underlayer film | Polymer | Crosslinking agent | Additive | Solvent |
|---|---|---|---|---|
| | (parts by mass) | (parts by mass) | (parts by mass) | (parts by mass) |
| UDL-1 | A1 (5) | - | - | PGMEA (95) |
| UDL-2 | A2 (5) | - | - | PGMEA (95) |
| UDL-3 | A3 (5) | - | - | PGMEA (95) |
| UDL-4 | A4 (5) | - | - | PGMEA (95) |
| UDL-5 | A5 (5) | - | - | PGMEA (95) |
| UDL-6 | A6 (5) | - | - | PGMEA (95) |
| UDL-7 | A7 (5) | - | - | PGMEA (95) |
| UDL-8 | A8 (5) | - | - | PGMEA (95) |
| UDL-9 | A9 (5) | - | - | PGMEA (95) |
| UDL-10 | A10 (5) | - | - | PGMEA /cyclohexanone (65/30) |
| UDL-11 | A11 (5) | - | - | PGMEA /cyclohexanone (65/30) |
| UDL-12 | A12 (5) | - | - | PGMEA /cyclohexanone (65/30) |
| UDL-13 | A13 (5) | - | - | PGMEA /cyclohexanone (65/30) |
| UDL-14 | A14 (5) | - | - | PGMEA (95) |
| UDL-15 | A2 (5) | C1 (1) | E1 (0.2) | PGMEA (95) |
| UDL-16 | A2 (5) | C2 (1) | E1 (0.2) | PGMEA (95) |
| UDL-17 | A2 (5) | - | B1 (3) | PGMEA (95) |
| Comparative UDL-1 | R1 (5) | - | E1 (0.2) | PGMEA (95) |

### [Resist Underlayer Film Pattern Formation Evaluation]

Each of the compositions (UDL-1 to -17 and comparative UDL-1) for forming a resist underlayer film was respectively applied onto a silicon wafer substrate having an SiO₂ film formed thereon, and baked at the temperature shown in Tables 6 and 7 for 60 seconds to form a resist underlayer film having a thickness of 60 nm.

A silicon-containing resist middle layer film material (SOG-1) was applied thereto, followed by baking at 220°C for 60 seconds to form a resist middle layer film having a thickness of 20 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a top coat having a thickness of 50 nm.

The silicon-containing resist middle layer film material (SOG-1) was prepared by dissolving a polymer represented by an ArF silicon-containing middle layer film polymer (SiP1) and a crosslinking catalyst (CAT1) in an organic solvent containing 0.1 mass% of FC-4430 (manufactured by Sumitomo 3M Limited) in the proportion shown in Table 3; and filtering the solution through a filter made of a fluororesin and having a pore size of 0.1 µm.

**[Table 3]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4000) |

The structural formulae of the ArF silicon-containing middle layer film polymer (SiP1) and the crosslinking catalyst (CAT1) used are shown below.

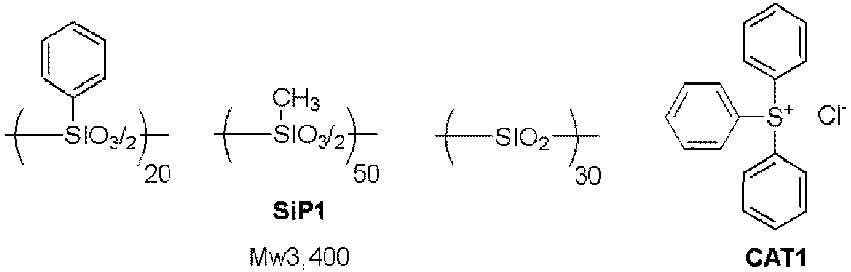

The resist upper layer film material (monolayer resist for ArF) was prepared by dissolving a polymer (RP1), an acid generator (PAG1), and a basic compound (Amine1), each in the proportion shown in Table 4, in a solvent containing 0.1% by mass of a surfactant FC-4430 (manufactured by Sumitomo 3M Limited), and filtering the solution through a 0.1-µm filter made of a fluororesin.

**[Table 4]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2500) |

The polymer (RP1), the acid generator (PAG1), and the basic compound (Amine1) used for the resist upper layer film material (monolayer resist for ArF) are shown below.

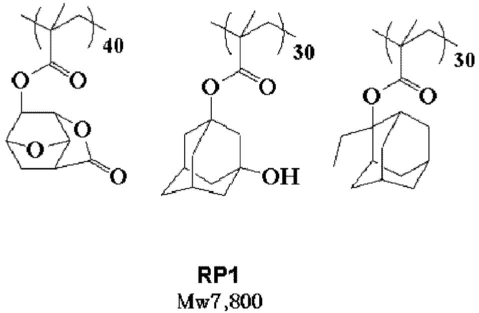

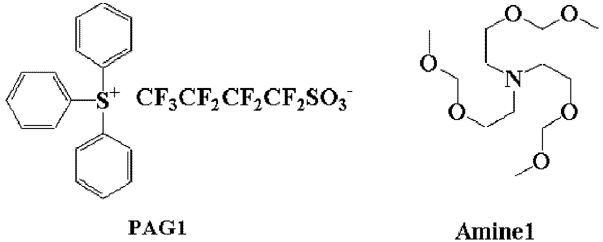

The liquid immersion top coat composition (TC-1) was prepared by dissolving a top coat polymer (PP1) in an organic solvent at the proportion shown in Table 5, and filtering the solution through a 0.1-µm filter made of a fluororesin.

**[Table 5]**

| | Polymer (parts by mass) | Organic solvent (parts by mass) |
|---|---|---|
| TC-1 | PP1 (100) | Diisoamyl ether (2700) |
| | | 2-methyl-1-butanol (270) |

The polymer (PP1) used for the liquid immersion top coat composition (TC-1) is shown below.

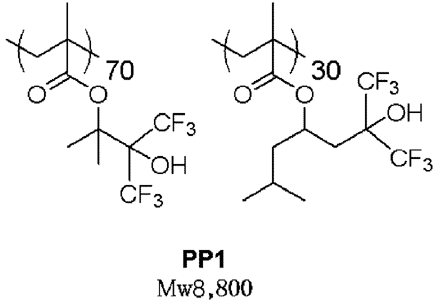

Then, the substrate was exposed to light with an ArF liquid immersion exposure apparatus (NSR-S610C manufactured by Nikon Corporation, NA: 1.30, σ: 0.98/0.78, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 45 nm 1 : 1 positive line-and-space pattern (a resist pattern).

Subsequently, the silicon-containing resist middle layer film material (SOG-1) was etched by dry etching by using an etching apparatus Telius manufactured by Tokyo Electron Ltd. while using the resist pattern as a mask to form a hard mask pattern. Then, the resist underlayer film was etched while using the obtained SOG-1 pattern as a mask to form a resist underlayer film pattern. The line size of the obtained resist underlayer film pattern was measured using CD-SEM (CG5000) manufactured by Hitachi High-Technologies Corp.

### Conditions in transferring resist pattern to silicon-containing resist middle layer film material (SOG-1)

Chamber pressure: 50 mT
RF-power (upper portion): 500 W
RF-power (lower portion): 300 W
CF₄ gas flow rate: 150 sccm
CHF₃ gas flow rate: 50 sccm
Time: 15 sec

### Conditions in transferring silicon-containing resist middle layer film material (SOG-1) pattern to resist underlayer film

Chamber pressure: 10 mT
RF-power (upper portion): 1,000 W
RF-power (lower portion): 300 W
CO₂ gas flow rate: 320 sccm
N₂ gas flow rate: 80 sccm
Time: 55 sec

After that, each substrate having the formed resist underlayer film pattern was subjected to plasma treatment by using an etching apparatus Telius manufactured by Tokyo Electron Ltd. under the following conditions, and the line size of the obtained resist underlayer film pattern was measured using CD-SEM (CG5000) manufactured by Hitachi High-Technologies Corp. The pattern cross section was observed with an electron microscope (S-4700) manufactured by Hitachi, Ltd.
Chamber pressure: 100 mT
RF-power (upper portion): 100 W
RF-power (lower portion): 3500 W
H₂ gas flow rate: 200 sccm
Time: 20 sec

The SiO₂ film was etched while using the resist underlayer film pattern obtained in the above evaluation as a mask. The etching conditions were as shown below. The line size of the obtained pattern was measured using CD-SEM (CG5000) manufactured by Hitachi High-Technologies Corp. The pattern cross section was observed with an electron microscope (S-4700) manufactured by Hitachi, Ltd.
Chamber pressure: 100 mT
RF-power (upper portion): 500 W
RF-power (lower portion): 300 W
CF₄ gas flow rate: 150 sccm
CHF₃ gas flow rate: 30 sccm
O₂ gas flow rate: 10 sccm
Time: 130 sec

### (Comparative Example 1-2)

As Comparative Example 1-2, the following evaluation was performed.

The composition (UDL-1) for forming a resist underlayer film was applied onto a silicon wafer substrate having an SiO₂ film formed thereon, and baked at 350°C for 60 seconds to form a resist underlayer film having a thickness of 60 nm. A silicon-containing resist middle layer film material (SOG-1) was applied thereto, followed by baking at 220°C for 60 seconds to form a resist middle layer film having a thickness of 20 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a top coat having a thickness of 50 nm.

Then, the substrate was exposed to light with an ArF liquid immersion exposure apparatus (NSR-S610C manufactured by Nikon Corporation, NA: 1.30, σ: 0.98/0.78, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 45 nm 1 : 1 positive line-and-space pattern (a resist pattern).

Subsequently, the substrate having the formed resist pattern was subjected to plasma treatment using an etching apparatus Telius manufactured by Tokyo Electron Ltd. under the following conditions, and the line size of the obtained resist pattern was measured using CD-SEM (CG5000) manufactured by Hitachi High-Technologies Corp. The pattern cross section was observed with an electron microscope (S-4700) manufactured by Hitachi, Ltd.
Chamber pressure: 100 mT
RF-power (upper portion): 100 W
RF-power (lower portion): 3500 W
H₂ gas flow rate: 200 sccm
Time: 20 sec

Subsequently, the silicon-containing resist middle layer film material (SOG-1) was etched by dry etching by using an etching apparatus Telius manufactured by Tokyo Electron Ltd. while using the resist pattern as a mask to form a hard mask pattern. Then, the resist underlayer film was etched while using the obtained SOG-1 pattern as a mask to form a resist underlayer film pattern. The line size of the obtained resist underlayer film pattern was measured using CD-SEM (CG5000) manufactured by Hitachi High-Technologies Corp.

### Conditions in transferring resist pattern to silicon-containing resist middle layer film material (SOG-1)

Chamber pressure: 50 mT
RF-power (upper portion): 500 W
RF-power (lower portion): 300 W
CF₄ gas flow rate: 150 sccm
CHF₃ gas flow rate: 50 sccm
Time: 15 sec

### Conditions in transferring silicon-containing resist middle layer film material (SOG-1) pattern to resist underlayer film

Chamber pressure: 10 mT
RF-power (upper portion): 1,000 W
RF-power (lower portion): 300 W
CO₂ gas flow rate: 320 sccm
N₂ gas flow rate: 80 sccm
Time: 55 sec

The SiO₂ film was etched while using the resist underlayer film pattern obtained in the above evaluation as a mask. The etching conditions were as shown below. The line size of the obtained pattern was measured using CD-SEM (CG5000) manufactured by Hitachi High-Technologies Corp. The pattern cross section was observed with an electron microscope (S-4700) manufactured by Hitachi, Ltd.
Chamber pressure: 100 mT
RF-power (upper portion): 500 W
RF-power (lower portion): 300 W
CF₄ gas flow rate: 150 sccm
CHF₃ gas flow rate: 30 sccm
O₂ gas flow rate: 10 sccm
Time: 130 sec

### (Comparative Example 1-3)

As Comparative Example 1-3, the following evaluation was performed.

The composition (UDL-1) for forming a resist underlayer film was applied onto a silicon wafer substrate having an SiO₂ film formed thereon, and baked at 350°C for 60 seconds to form a resist underlayer film having a thickness of 60 nm. Subsequently, the resist underlayer film before pattern formation was subjected to plasma irradiation treatment under the same conditions as the plasma irradiation conditions of the resist underlayer film pattern of the Examples. A silicon-containing resist middle layer film material (SOG-1) was applied thereto, followed by baking at 220°C for 60 seconds to form a resist middle layer film having a thickness of 20 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a top coat having a thickness of 50 nm.

Then, the substrate was exposed to light with an ArF liquid immersion exposure apparatus (NSR-S610C manufactured by Nikon Corporation, NA: 1.30, σ: 0.98/0.78, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 45 nm 1 : 1 positive line-and-space pattern (a resist pattern).

Subsequently, the silicon-containing resist middle layer film material (SOG-1) was etched by dry etching by using an etching apparatus Telius manufactured by Tokyo Electron Ltd. while using the resist pattern as a mask to form a hard mask pattern. Then, the resist underlayer film was etched while using the obtained SOG-1 pattern as a mask to form a resist underlayer film pattern. The line size of the obtained resist underlayer film pattern was measured using CD-SEM (CG5000) manufactured by Hitachi High-Technologies Corp.

### Conditions in transferring resist pattern to silicon-containing resist middle layer film material (SOG-1)

Chamber pressure: 50 mT
RF-power (upper portion): 500 W
RF-power (lower portion): 300 W
CF₄ gas flow rate: 150 sccm
CHF₃ gas flow rate: 50 sccm
Time: 15 sec

### Conditions in transferring silicon-containing resist middle layer film material (SOG-1) pattern to resist underlayer film

Chamber pressure: 10 mT
RF-power (upper portion): 1,000 W
RF-power (lower portion): 300 W
CO₂ gas flow rate: 320 sccm
N₂ gas flow rate: 80 sccm
Time: 55 sec

The SiO₂ film was etched while using the resist underlayer film pattern obtained in the above evaluation as a mask. The etching conditions were as shown below. The line size of the obtained pattern was measured using CD-SEM (CG5000) manufactured by Hitachi High-Technologies Corp. The pattern cross section was observed with an electron microscope (S-4700) manufactured by Hitachi, Ltd.
Chamber pressure: 100 mT
RF-power (upper portion): 500 W
RF-power (lower portion): 300 W
CF₄ gas flow rate: 150 sccm
CHF₃ gas flow rate: 30 sccm
O₂ gas flow rate: 10 sccm
Time: 130 sec

The results of the Examples and Comparative Examples are shown below in Tables 6 and 7. When the line size after the plasma irradiation changed by less than 5% of the line size before the plasma irradiation, the evaluation "A (very good)" was given, when 5% or more and less than 10%, "B (good)", and when 10% or more, "C (poor)".

**[Table 6]**

| Example | Composition for forming resist underlayer film | Baking temperature | Pattern to be plasma-irradiate d | CD before plasma irradi-ation (nm) | LWR before plasma irradiation (nm) | Change in CD between before and after plasma irradi-ation | Cross-sectional profile after plasma irradiation | LWR after plasma irradi-ation (nm) | CD of resist underlayer film pattern (nm) | LWR of resist underlayer film pattern (nm) | LWR after substrate processing (nm) |
|---|---|---|---|---|---|---|---|---|---|---|---|
| Example 1-1 | UDL-1 | 350°C | *1 | 45.2 | 2.99 | A | Rectangular | 2.38 | - | - | 2.20 |
| Example 1-2 | UDL-2 | 350°C | *1 | 44.4 | 2.92 | B | Rectangular | 2.33 | - | - | 2.04 |
| Example 1-3 | UDL-3 | 350°C | *1 | 45.3 | 3.01 | A | Rectangular | 2.42 | - | - | 2.12 |
| Example 1-4 | UDL-4 | 350°C | *1 | 45.4 | 2.96 | A | Rectangular | 2.35 | - | - | 2.07 |
| Example 1-5 | UDL-5 | 350°C | *1 | 45.2 | 3.01 | B | Rectangular | 2.4 | - | - | 2.13 |
| Example 1-6 | UDL-6 | 350°C | *1 | 45.3 | 300 | B | Rectangular | 2.39 | - | - | 2.08 |
| Example 1-7 | UDL-7 | 350°C | *1 | 45.5 | 3.05 | A | Rectangular | 2.43 | - | - | 2.14 |
| Example 1-8 | UDL-8 | 350°C | *1 | 45.4 | 3.05 | A | Rectangular | 2.46 | - | - | 2.15 |
| Example 1-9 | UDL-9 | 350°C | *1 | 45.4 | 3.03 | A | Rectangular | 2.42 | - | - | 2.13 |
| Example 1-10 | UDL-10 | 350°C | *1 | 45.7 | 2.96 | A | Rectangular | 2.35 | - | - | 2.07 |

**[Table 7]**

| Example | Composition for forming resist underlayer film | Baking temperature | Pattern to be plasma-irradiated | CD before plasma irradiation (nm) | LWR before plasma irradiation (nm) | Change in CD between before and after plasma irradiation | Cross-sectional profile after plasma irradiation | LWR after plasma irradiation (nm) | CD of resist underlayer film pattern (nm) | LWR of resist underlayer film pattern (nm) | LWR after substrate processing (nm) |
|---|---|---|---|---|---|---|---|---|---|---|---|
| Example 1-11 | UDL-11 | 350°C | *1 | 45.8 | 2.92 | A | Rectangular | 2.3 | - | - | 1.99 |
| Example 1-12 | UDL-12 | 350°C | *1 | 45.5 | 2.98 | A | Rectangular | 2.37 | - | - | 2.05 |
| Example 1-13 | UDL-13 | 350°C | *1 | 45.3 | 2.99 | A | Rectangular | 2.38 | - | - | 2.07 |
| Example 1-14 | UDL-14 | 350°C | *1 | 44.8 | 3.02 | B | Rectangular | 2.43 | - | - | 2.14 |
| Example 1-15 | UDL-15 | 350°C | *1 | 44.5 | 2.94 | A | Rectangular | 2.32 | - | - | 2.01 |
| Example 1-16 | UDL-16 | 350°C | *1 | 44.4 | 2.94 | A | Rectangular | 2.32 | - | - | 2.02 |
| Example 1-17 | UDL-17 | 350°C | *1 | 44.3 | 2.93 | A | Rectangular | 2.33 | - | - | 204 |
| Comparative Example 1-1 | Comparative UDL-1 | 250°C | *1 | 42.8 | 3.45 | C | Distorted | 4.54 | - | - | 4.27 |
| Comparative Example 1-2 | UDL-1 | 350°C | *2 | 45.4 | 3.13 | C | Distorted | 5.44 | - | - | - |
| Comparative Example 1-3 | UDL-1 | 350°C | *3 | - | - | - | - | - | 46.1 | 3.57 | 3.38 |

In Tables 6 and 7, "*1" indicates a resist underlayer film pattern, "*2" indicates a resist pattern, and "*3" indicates a resist underlayer film.

As shown in Tables 6 and 7, in Examples 1-1 to 1-17, the change in CD between before and after plasma irradiation was smaller than in Comparative Example 1-1, and improvement in LWR achieved by plasma irradiation was observed. Furthermore, it was observed that the SiO₂ film pattern processed while using the obtained pattern as a mask had better LWR than in Comparative Example 1-1, and were suitably usable for fine processing.

In Comparative Example 1-1, where comparative UDL-1, not containing an aromatic ring, was used, the change in CD between before and after plasma irradiation was greater than in Examples 1-1 to 1-17, distortion was observed in the cross-sectional profile of the line pattern, and it was also observed that LWR was insufficient.

Meanwhile, in Comparative Example 1-2, where the resist pattern was subjected to plasma irradiation but the plasma irradiation step was not performed on the resist underlayer film pattern, the change in line size was great, and distortion in the line pattern was observed. The processing of the SiO₂ film to achieve the pattern was performed while using the obtained pattern, but it was not possible to transfer the pattern to the SiO₂ film, possibly because dry etching of the resist pattern with the fluorocarbon-based gas was insufficient.

In Comparative Example 1-3, where the resist pattern was transferred to the plasma-irradiated resist underlayer film, the LWR of the resist underlayer film pattern was greater than in Examples 1-1 to 1-17, and the LWR of the SiO₂ film pattern processed while using the obtained pattern as a mask was also insufficient. In plasma irradiation of an unpatterned resist underlayer film, it is expected that there is a limitation to the uniform modification of the entire film due to thickening of the resist underlayer film. On the other hand, in the plasma irradiation of the resist underlayer film pattern of the present invention, the film modification on the surface of the pattern sidewalls progresses efficiently. It can be conjectured that, therefore, the edge roughness of the resist underlayer film pattern was improved by the plasma irradiation.

### [Wet Peeling Evaluation of SOG Film on Resist Underlayer Film Pattern]

The SOG film remaining on the resist underlayer film pattern was immersed in a 25% aqueous solution of tetramethylammonium hydroxide at 70°C for 10 minutes, and the cross-sectional profile of the resist underlayer film pattern was observed with an electron microscope (S-4700) manufactured by Hitachi, Ltd.

When the SOG film was removed and the cross-sectional profile of the resist underlayer film pattern was rectangular, the evaluation "Rectangular" was given, and when the SOG film was removed but the cross-sectional profile of the resist underlayer film pattern was distorted, the evaluation "Poor" was given. The results are shown in Table 8.

The evaluated resist underlayer film patterns are given below.
Example 2-1: the resist underlayer film pattern prepared in Example 1-1, after plasma irradiation
Comparative Example 2-1: the resist underlayer film pattern prepared in Comparative Example 1-1, after plasma irradiation
Comparative Example 2-2: the resist underlayer film pattern prepared in Comparative Example 1-3
Comparative Example 2-3: the resist underlayer film pattern prepared in Example 1-1, before plasma irradiation

**[Table 8]**

| Example | Composition for forming resist underlayer film | Baking temperature | Pattern to be plasma-irradiated | Pattern profile after peeling SOG |
|---|---|---|---|---|
| Example 2-1 | UDL-1 | 350°C | Resist underlayer film pattern | Rectangular |
| Comparative Example 2-1 | Comparative UDL-1 | 350°C | Resist underlayer film pattern | Poor |
| Comparative Example 2-2 | UDL-1 | 350°C | Resist underlayer film | Poor |
| Comparative Example 2-3 | UDL-1 | 350°C | No plasma irradiation performed | Poor |

As shown in Table 8, in Example 2-1, it was observed that the cross-sectional profile of the resist underlayer film pattern after removing the SOG film was rectangular compared to Comparative Examples 2-1 and 2-2. Meanwhile, in Comparative Example 2-3, where the resist underlayer film pattern was not subjected to plasma irradiation, it was observed that the resist underlayer film pattern after removing the SOG film was distorted, possibly because resistance to the peeling solution was insufficient.

It was revealed that when the resist underlayer film pattern of the present invention is subjected to plasma irradiation, the quality of the resist underlayer film pattern sidewalls is modified, and resistance to peeling solutions is enhanced. Since the silicon-containing film can be removed suitably using a peeling solution, the pattern of the present invention is extremely useful as a core material for a sidewall spacer method.

As described above, the inventive resist underlayer film patterning process makes it possible to form a resist underlayer film pattern that exhibits excellent edge roughness by employing plasma irradiation, and therefore, is extremely useful for next-generation fine-processing processes.

The present description includes the following embodiments.
[1] A patterning process for forming a resist underlayer film pattern on a substrate, comprising the steps of:
   (i-1) applying a composition for forming a resist underlayer film onto a substrate, followed by heating to form a resist underlayer film;
   (i-2) applying a composition for forming a silicon-containing resist middle layer film onto the resist underlayer film, followed by heating to form a silicon-containing resist middle layer film;
   (i-3) forming a resist upper layer film on the silicon-containing resist middle layer film;
   (i-4) subjecting the resist upper layer film to pattern exposure and then development with a developer to form a pattern in the resist upper layer film;
   (i-5) forming a resist underlayer film pattern by etching multiple times while using the pattern of the resist upper layer film as a mask; and
   (i-6) subjecting the resist underlayer film pattern to plasma irradiation, wherein
      the composition for forming a resist underlayer film contains a resin having an aromatic ring, and
      a plasma used in the plasma irradiation in the step (i-6) etches the resist underlayer film less than an etching gas used in the step (i-5) of forming the resist underlayer film pattern by etching the resist underlayer film.
[2] A patterning process for forming a resist underlayer film pattern on a substrate, comprising the steps of:
   (ii-1) applying a composition for forming a resist underlayer film onto a substrate, followed by heating to form a resist underlayer film;
   (ii-2) forming an inorganic hard mask middle layer film selected from a silicon oxide film, a silicon nitride film, and a silicon oxynitride film on the resist underlayer film;
   (ii-3) forming a resist upper layer film on the inorganic hard mask middle layer film;
   (ii-4) subjecting the resist upper layer film to pattern exposure and then development with a developer to form a pattern in the resist upper layer film;
   (ii-5) forming a resist underlayer film pattern by etching multiple times while using the pattern of the resist upper layer film as a mask; and
   (ii-6) subjecting the resist underlayer film pattern to plasma irradiation, wherein
      the composition for forming a resist underlayer film contains a resin having an aromatic ring, and
      a plasma used in the plasma irradiation in the step (ii-6) etches the resist underlayer film less than an etching gas used in the step (ii-5) of forming the resist underlayer film pattern by etching the resist underlayer film.
[3] The patterning process according to [1] or [2], comprising, after the step of performing plasma irradiation, a step of forming the pattern directly or indirectly on the substrate while using the plasma-irradiated resist underlayer film pattern as an etching mask.
[4] The patterning process according to any one of [1] to [3], wherein the step of performing plasma irradiation is performed under an atmosphere of N₂, NF₃, H₂, fluorocarbon, a rare gas, or a mixture thereof.
[5] The patterning process according to any one of [1] to [4], wherein the step of performing plasma irradiation is performed under an atmosphere containing hydrogen or helium.
[6] The patterning process according to any one of [1] to [5], wherein the composition for forming a resist underlayer film comprises (A) a resin, being:
   (a) a polymer having an aromatic ring in a main chain and having a weight-average molecular weight of 2,500 or higher and 20,000 or lower as measured by gel permeation chromatography in terms of polystyrene;
   (b) an aromatic ring-containing compound having a weight-average molecular weight of 600 or more and 3,000 or less as measured by gel permeation chromatography in terms of polystyrene; or a combination thereof.
[7] The patterning process according to [6], wherein the resin (A) has at least one crosslinkable group selected from a vinyl group, an allyl group, an allyloxy group, an ethynyl group, a propargyl group, a propargyloxy group, an epoxy group, an oxetanyl group, and a hydroxy group.
[8] The patterning process according to any one of [1] to [7] for forming a half-pitch pattern of the pattern of the resist upper layer film on the substrate, the patterning process comprising,
   after the step of subjecting the resist underlayer film pattern to plasma irradiation, the steps of:
   forming an inorganic silicon film comprising any of polysilicon, amorphous silicon, silicon oxide, silicon nitride, silicon oxynitride, silicon carbide, and composite materials thereof by a CVD method or an ALD method to cover the resist underlayer film pattern; and
   removing the resist underlayer film pattern by dry etching or with a peeling solution to form an inorganic silicon film pattern having a half pitch of the pattern of the resist upper layer film.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A patterning process for forming a resist underlayer film pattern on a substrate, comprising the steps of:
(i-1) applying a composition for forming a resist underlayer film onto a substrate, followed by heating to form a resist underlayer film;
(i-2) applying a composition for forming a silicon-containing resist middle layer film onto the resist underlayer film, followed by heating to form a silicon-containing resist middle layer film;
(i-3) forming a resist upper layer film on the silicon-containing resist middle layer film;
(i-4) subjecting the resist upper layer film to pattern exposure and then development with a developer to form a pattern in the resist upper layer film;
(i-5) forming a resist underlayer film pattern by etching multiple times while using the pattern of the resist upper layer film as a mask; and
(i-6) subjecting the resist underlayer film pattern to plasma irradiation, wherein
the composition for forming a resist underlayer film contains a resin having an aromatic ring, and
a plasma used in the plasma irradiation in the step (i-6) etches the resist underlayer film less than an etching gas used in the step (i-5) of forming the resist underlayer film pattern by etching the resist underlayer film, or
a patterning process for forming a resist underlayer film pattern on a substrate, comprising the steps of:
(ii-1) applying a composition for forming a resist underlayer film onto a substrate, followed by heating to form a resist underlayer film;
(ii-2) forming an inorganic hard mask middle layer film selected from a silicon oxide film, a silicon nitride film, and a silicon oxynitride film on the resist underlayer film;
(ii-3) forming a resist upper layer film on the inorganic hard mask middle layer film;
(ii-4) subjecting the resist upper layer film to pattern exposure and then development with a developer to form a pattern in the resist upper layer film;
(ii-5) forming a resist underlayer film pattern by etching multiple times while using the pattern of the resist upper layer film as a mask; and
(ii-6) subjecting the resist underlayer film pattern to plasma irradiation, wherein
the composition for forming a resist underlayer film contains a resin having an aromatic ring, and
a plasma used in the plasma irradiation in the step (ii-6) etches the resist underlayer film less than an etching gas used in the step (ii-5) of forming the resist underlayer film pattern by etching the resist underlayer film.

2. The patterning process according to claim 1, comprising, after the step of performing plasma irradiation, a step of forming the pattern directly or indirectly on the substrate while using the plasma-irradiated resist underlayer film pattern as an etching mask.

3. The patterning process according to claim 1 or 2, wherein the step of performing plasma irradiation is performed under an atmosphere of N₂, NF₃, H₂, fluorocarbon, a rare gas, or a mixture thereof.

4. The patterning process according to any one of claims 1 to 3, wherein the step of performing plasma irradiation is performed under an atmosphere containing hydrogen or helium.

5. The patterning process according to any one of claims 1 to 4, wherein the composition for forming a resist underlayer film comprises (A) a resin, being:
(a) a polymer having an aromatic ring in a main chain and having a weight-average molecular weight of 2,500 or higher and 20,000 or lower as measured by gel permeation chromatography in terms of polystyrene;
(b) an aromatic ring-containing compound having a weight-average molecular weight of 600 or more and 3,000 or less as measured by gel permeation chromatography in terms of polystyrene; or a combination thereof.

6. The patterning process according to claim 5, wherein the resin (A) has at least one crosslinkable group selected from a vinyl group, an allyl group, an allyloxy group, an ethynyl group, a propargyl group, a propargyloxy group, an epoxy group, an oxetanyl group, and a hydroxy group.

7. The patterning process according to according to any one of claims 1 to 6 for forming a half-pitch pattern of the pattern of the resist upper layer film on the substrate, the patterning process comprising,
after the step of subjecting the resist underlayer film pattern to plasma irradiation, the steps of:
forming an inorganic silicon film comprising any of polysilicon, amorphous silicon, silicon oxide, silicon nitride, silicon oxynitride, silicon carbide, and composite materials thereof by a CVD method or an ALD method to cover the resist underlayer film pattern; and
removing the resist underlayer film pattern by dry etching or with a peeling solution to form an inorganic silicon film pattern having a half pitch of the pattern of the resist upper layer film.
